# EUROPEAN PATENT SPECIFICATION

(11) **EP 1 739 114 B1**
(45) Date of publication and mention of the grant of the patent: **17.12.2008**
(21) Application number: 05734610.8
(22) Date of filing: 25.04.2005
(51) Int. Cl.: C08G 73/10, B32B 15/08, B32B 27/34, H05K 1/03

(54) **POLYIMIDE RESIN, MULTILAYER FILM, MULTILAYER FILM WITH METAL LAYER, AND SEMICONDUCTOR DEVICE**
POLYIMIDHARZ, MEHRSCHICHTFOLIE, MEHRSCHICHTFOLIE MIT METALLSCHICHT UND HALBLEITERELEMENT
RÉSINE POLYIMIDE, FILM MULTICOUCHE, FILM MULTICOUCHE À COUCHE MÉTALLIQUE, ET DISPOSITIF SEMI-CONDUCTEUR

(30) Priority: 20.05.2004 JP 2004150222
(43) Date of publication of application: 03.01.2007
(73) Proprietor: TORAY INDUSTRIES, INC., Tokyo 103-8666 (JP)
(72) Inventor: WATANABE, Takuo, Shiga 520-2144 (JP)
(74) Representative: Oser, Andreas
(86) International application number: PCT/JP2005/007766
(87) International publication number: WO 2005/113645

(56) References cited:
- EP-A1- 0 349 008
- EP-A1- 0 349 010
- JP-A- 5 039 363
- JP-A- 9 067 559
- JP-A- 11 116 672
- JP-A- 11 292 968
- JP-A- 2004 250 577
- US-A- 5 723 571
- US-A- 5 866 250

## Description

### Field of the Art

The invention relates to an innovative polyimide resin. More particularly, the invention relates to a polyimide resin soluble in an organic solvent, excellent in heat resistance, and widely usable in an electronic industrial field as a liquid crystal oriented film, a sealing agent, a protection film, an adhesive for a multilayer substrate, as well as a flexible printed circuit board (FPC).

### Prior Art

Polyimide resins obtained by reaction of tetracarboxylic acid dianhydrides and diamines have been widely used an electronic industrial field because of their excellent heat resistance and solvent resistance.

As a substrate for FPC has been widely used a "three-layer laminate" product obtained by laminating a copper foil on a flexible, heat resistant, and insulating film such as polyimide film via an adhesive layer of an epoxy resin, a phenol resin, an acrylonitrile resin, or a butadiene resin. However, since the resin to be used for the adhesive layer in the "three-layer laminate" product is inferior in the heat resistance to a polyimide film, in the case the "three-layer laminate" product is used for a COF (Chip on Film) in which bonding of an IC (semiconductor chip) is to be carried out at a temperature as high as 300 to 400°C and for a multilayer flexible substrate whose fabrication involves press at a high temperature, thermal decomposition of the adhesive layer is caused to result in considerable subsidence of the wiring in the adhesive layer and a possible problem of disconnection. Further, on the other than there is another problem that since the above-mentioned resin contains impurity ion, the insulation reliability is lowered.

Recently, with respect to the "three-layer laminate" product, a substrate for an FPC is proposed which is obtained by laminating a metal foil such as a copper foil by heat pressure bonding at a temperature as high as 300°C or higher on a multilayer film consisting of a polyimide base film and a thermoplastic polyimide resin layered as an adhesive layer on the surface of the base film (reference to Patent Document No. 1). Since the substrate for an FPC has a high heat resistance, it can be used for a COF and a multilayer flexible substrate, however in the case a thermoplastic polyimide resin is laminated on the polyimide film, at first a solution of a polyamide acid, which is a precursor of the thermoplastic polyimide resin, is applied and then heated to convert the polyamide acid into a polyimide and therefore, it is required to carry out heating treatment continuously at a high temperature before the copper foil is stuck and it results in a problem relevant to the production cost.

On the other hand, because a step of heating treatment after formation of an adhesive layer can be skipped by using a soluble polyimide resin soluble in an organic solvent for the adhesive layer, a soluble polyimide using a siloxane type diamine as a diamine component is proposed (reference to Patent Document No. 2). If the siloxane component is increased in the polyimide resin main chain, the solubility in a solvent is improved, however the glass transition temperature of the polyimide resin is lowered and accordingly it results in a problem relevant to heat resistance that the wiring subsides in the adhesive layer in process of bonding of an IC or high temperature press.

Further, a soluble polyimide using a diamine having a fluorene skeleton as a diamine component and having a high glass transition temperature is proposed (reference to Patent Document No. 3). However, although the solubility in an organic solvent is improved owing to the existence of the fluorene skeleton in the side chains of the polyimide resin, in the case the diamine component is solely the diamine having the fluorene skeleton, the glass transition temperature of the resin becomes 350°C or higher and the adhesiveness may decrease in the case the resin is used for an adhesive layer for an FPC. Even if addition is in a small amount, the glass transition temperature is increased and therefore an aliphatic diamine is used in combination for adjusting the glass transition temperature. However, if the aliphatic diamine is added, the polyimide resin tends to be thermally decomposed and it results in a problem relevant to the heat resistance.

Further a soluble polyimide is also proposed, which is produced by using diphenylsulfonetetracarboxylic acid dianhydride and/or ethylene glycol bistrimellitic dianhydride as an acid component and an aromatic diamine and a siloxane type diamine as diamine components (reference to Patent Document No. 4). However, in the use for an FPC, the properties' such as the adhesiveness and soldering heat resistance are insufficient. Patent Document No. 1: Japanese Patent Application Laid-Open (JP-A) No. 2002-114848 (p. 6 to 8)
Patent Document No. 2: JP-A No. 1-121325 (p. 2 to 6)
Patent Document No. 3: JP-A No. 5-39363 (p. 4 to 6)
Patent Document No. 4: JP-A No. 9-67559 (p. 3 to 19)

### Disclosure of the Invention

### Problem to be Solved by the Invention

In view of the above state of the art, it is an object of the invention to provide an innovative polyimide resin having high solubility in an organic solvent and good heat resistance. Another object of the invention is to provide a laminate film and a metal-bearing laminate film with good adhesiveness and high soldering heat resistance. Further, the other object of the invention is to provide a semiconductor device with high reliability.

### Means for Solving the Problem

That is, the invention provides a polyimide resin containing at least an acid dianhydride residual group and a diamine residual group and having a glass transition temperature in a range from 200 to 320°C, wherein the diamine residual group includes a residual group of a siloxane type diamine defined by the formula (1) and a residual group of a fluorene type diamine defined by the formula (2) in 2 to 40% by mole of the siloxane type diamine residual group and 4 to 82% by mole of the fluorene type diamine residual group in the total diamine residual groups, the acid dianhydride residual group includes a residual group of at least one acid dianhydride selected from tetracarboxylic acid dianhydrides defined by the formula (3) and tetracarboxylic acid dianhydrides defined by the formula (4): 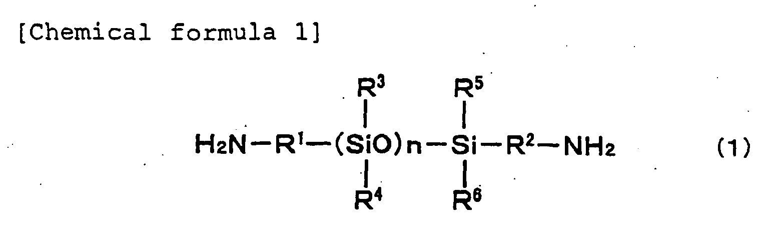 wherein the reference character n denotes a numeral in a range from 1 to 30; R¹ and R² may be same or different and independently denote an alkylene group of 1 to 30 carbon atoms or a phenylene group; R³ to R⁶ may be same or different and independently denote an alkyl group of 1 to 30 carbon atoms, a phenyl group, or a phenoxy group: 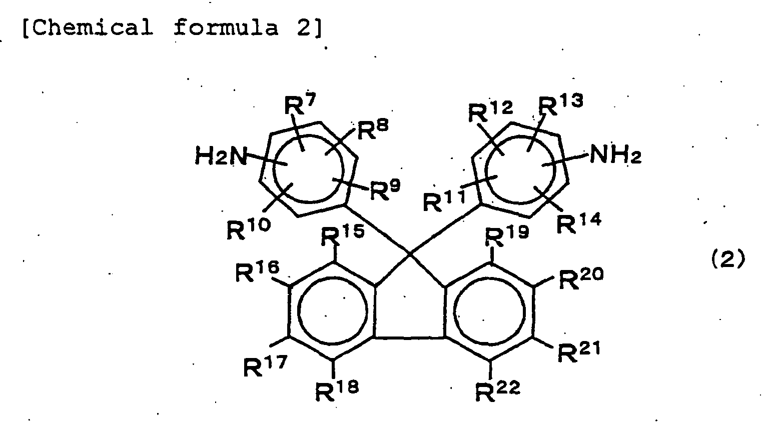 wherein R⁷ to R²² may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, and a cyano group: 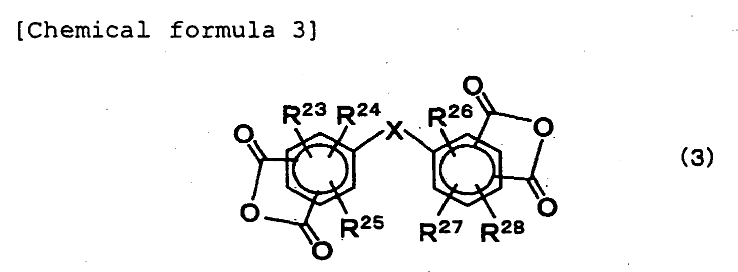 wherein X is selected from O, CO, S, SO, CH₂, C(CH₃)₂, and C (CF₃)₂; R²³ to R²⁸ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group: and 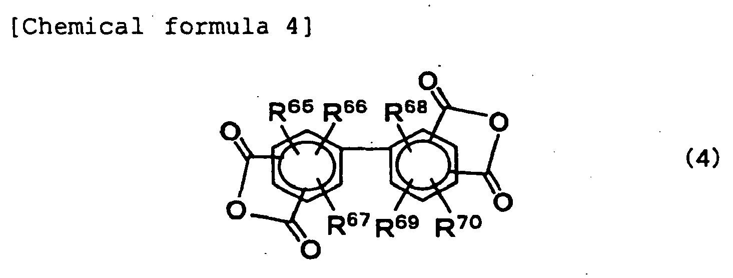 wherein R⁶⁵ to R⁷⁰ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group.

### Effects of the Invention

According to the invention, an innovative polyimide resin having sufficient solubility to an organic solvent and excellent heat resistance can be obtained. Further, a laminate film comprising the polyimide resin and a heat resistant insulation film laminated thereon is obtained and also is obtained a metal layer-bearing laminate film having high adhesiveness and high soldering heat resistance by laminating the metal layer on the laminate film. Further, since the metal layer-bearing laminate film is excellent also in the mechanical heat resistance and scarcely causes resin deformation in the process of applying pressure to the resin at a high temperature such as the process of binding of an IC or high temperature press, a semiconductor device with high reliability can be provided.

### Brief Description of Drawings

[Fig. 1] A schematic view showing an embodiment of a roll laminator to be used in the invention.
[Fig. 2] A schematic view showing another embodiment of a roll laminator to be used in the invention.
[Fig. 3] A schematic view showing another embodiment of a roll laminator to be used in the invention.
[Fig. 4] A schematic view showing another embodiment of a roll laminator to be used in the invention.

1. a heating roll (upper)
2. a heating roll (lower)
3. a metal foil-unrolling roll
4. a laminate film-unrolling roll
5. a product-rolling roll
6. a protection film-unrolling roll
7. a protection film-rolling roll
8. a metal foil
9. a laminate film
10. a protection film

### Best Modes of the Embodiments of the Invention

The polyimide resin of the invention is a soluble polyimide resin soluble in an organic solvent. Hereinafter, the solubility means being soluble in an organic solvent. In the invention that the polyimide resin is soluble in an organic solvent means that the resin is dissolved in a concentration of 5% by weight or higher, preferably 10% by weight or higher, and even more preferably 15% by weight or higher in an organic solvent.

Further, since the polyimide resin of the invention is to be used preferably as an adhesive layer for an FPC, the glass transition temperature of the polyimide resin is in a range from 200 to 320°C, preferably from 220 to 300°C, and even more preferably 240 to 280°C. If the glass transition temperature is in the range, the deformation of the resin is slight in the process of applying pressure to the resin at a high temperature and the adhesiveness is high, so that a semiconductor device with high reliability can be obtained if the resin is used for the adhesive layer for an FPC.

The adhesiveness in the invention is evaluated based on the adhesion strength measured immediately after lamination of a metal layer on the laminate film in normal state. The adhesion strength in the normal state is preferably 6 N/cm or higher, more preferably 8 N/cm or higher, and even more preferably 10 N/cm or higher. The adhesion strength is measured using a metal layer-bearing laminate film obtained by laminating a heat resistant resin layer containing the polyimide resin on a heat resistant insulation film and further laminating a metal layer on the heat resistant resin layer. The metal layer of the metal layer-bearing laminate film is etched in a pattern with a line width of 50 µm to 2 mm and the resulting metal layer is peeled at 50 mm/min speed in 90° direction to the laminate film to measure the peeling strength as the adhesion strength. At the time of the measurement, separation is caused between the heat resistant insulation film and the heat resistant resin layer or between the metal layer and the heat resistant resin layer or by coagulation break in heat resistant layer or by combination of them and in general, separation occurs in the weakest part of the adhesiveness.

In the invention, the heat resistance is measured as the soldering heat resistance of the metal layer-bearing laminate film after moisture absorption. After the metal layer-bearing laminate film is left in condition of 40°C/90% RH for 1 to 240 hours for moisture absorption, the film is floated on a solder bath set at a prescribed temperature for 1 minute and whether appearance changes or not is observed and the highest temperature of the solder bath at which no appearance change occurs is defined as the soldering heat resistance. In this connection, the appearance change means blister and color change of the heat resistant resin layer.

The soldering heat resistance in the invention is preferably 240°C or higher, more preferably 260°C or higher, and even more preferably 280°C or higher.

In the invention, the composition of the polyimide resin is investigated to find that an innovative soluble polyimide resin having the above-mentioned properties can be obtained by using a a residual group of siloxane type diamine defined by the formula (1) and a residual group of a fluorene type diamine defined by the formula (2) in combination as diamine residual groups in amounts of 2 to 40% by mole, preferably 6 to 36% by mole, and more preferably 9 to 32% by mole of the siloxane type diamine residual group and 4 to 82% by mole, preferably 8 to 76% by mole, and more preferably 16 to 72% by mole of the fluorene type diamine residual group, respectively, in the total diamine residual groups. 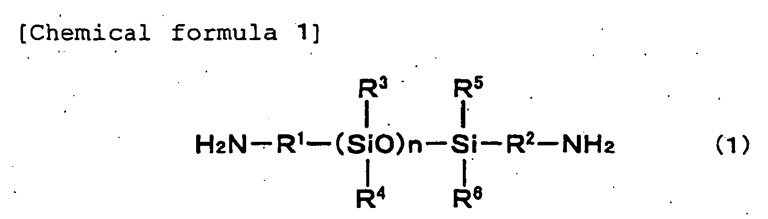 (the reference character n denotes a numeral in a range from 1 to 30; R¹ and R² may be same or different and independently denote an alkylene group of 1 to 30 carbon atoms or a phenylene group; R³ to R⁶ may be same or different and independently denote an alkyl group of 1 to 30 carbon atoms, a phenyl group, or a phenoxy group). 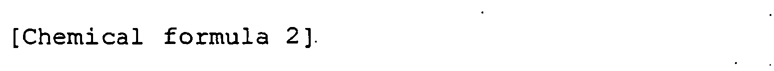 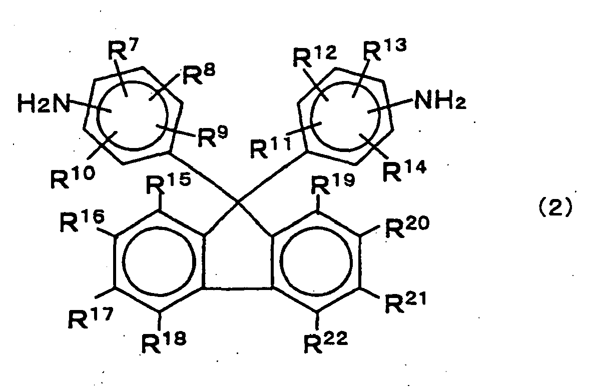 (R⁷ to R²² may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, and a cyano group).

In the formula (1), the alkylene group and the alkyl group means an alkylene group of 1 to 30 carbon atoms and an alkyl group of 1 to 30 carbon atoms.

Since a long chain siloxane type diamine defined by the formula (1) is used, the reactivity is deteriorated and the polymerization degree of the polymer is lowered and heat resistance is decreased and thus it is not preferable. The numeral defined by the reference character n in the formula (1) is in a range from 1 to 30, preferably from 1 to 15, and more preferably from 1 to 5.

Practical examples of the siloxane type diamine defined by the formula (1) are
1,1,3,3-tetramethyl-1,3-bis(4-aminophenyl)disiloxane,
1,1,3,3-tetraphenoxy-1,3-bis(4-aminoethyl)disiloxane,
1,1,3,3,5,5-hexamethyl-1,5-bis(4-aminophenyl)trisiloxane,
1,1,3,3-tetraphenyl-1,3-bis(2-aminoethyl)disiloxane,
1,1,3,3-tetraphenyl-1,3-bis(3-aminopropyl)disiloxane,
1,1,5,5-tetraphenyl-3,3-dimethyl-1,5-bis(3-aminopropyl)tris iloxane,
1,1,5,5-tetraphenyl-3,3-dimethyl-1,5-bis(4-aminobutyl)trisi loxane,
1,1,5,5-tetraphenyl-3,3-dimethoxy-1,5-bis(5-aminopentyl)tri siloxane,
1,1,3,3-tetramethyl-1,3-bis(2-aminoethyl)disiloxane,
1,1,3,3-tetramethyl-1,3-bis(3-aminopropyl)disiloxane,
1,1,3,3-tetramethyl-1,3-bis(4-aminobutyl)disiloxane,
1,3-dimethyl-1,3-dimethoxy-1,3-bis(4-aminobutyl)disiloxane,
1,1,5,5-tetramethyl-3,3-dimethoxy-1,5-bis(2-aminoethyl)tris iloxane,
1,1,5,5-tetramethyl-3,3-dimethoxy-1,5-bis(4-aminobutyl)tris iloxane,
1,1,5,5-tetramethyl-3,3-dimethoxy-1,5-bis(5-aminopentyl)tri siloxane,
1,1,3,3,5,5-hexamethyl-1,5-bis(3-aminopropyl)trisiloxane,
1,1,3,3,5,5-hexaethyl-1,5-bis(3-aminopropyl)trisiloxane, and
1,1,3,3,5,5-hexapropyl-1,5-bis(3-aminopropyl)trisiloxane.
The siloxane type diamines exemplified above may be used alone or two or more of them may be used in form of a mixture.

Practical examples of the fluorene type diamine defined by the formula (2) are 9,9-bis(4-aminophenyl)fluorene,
9,9-bis(3-aminophenyl)fluorene,
9,9-bis(3-methyl-4-aminophenyl)fluorene,
9,9-bis(3,5-dimethyl-4-aminophenyl)fluorene,
9,9-bis(3-methoxy-4-aminophenyl)fluorene,
9,9-bis(4-aminophenyl)fluorene-4-carboxylic acid,
9,9-bis(4-aminophenyl)fluorene-4-methyl,
9,9-bis(4-aminophenyl)fluorene-4-methoxy,
9,9-bis(4-aminophenyl)fluorene-4-ethyl,
9,9-bis(4-aminophenyl)fluorene-4-sulfone,
9,9-bis(4-aminophenyl)fluorene-3-carboxylic acid, and
9,9-bis(4-aminophenyl)fluorene-3-methyl. The fluorene type diamines exemplified above may be used alone or two or more of them may be used in form of a mixture.

If the polyimide resin of the invention contains a residual group of one or more of aromatic diamine selected from aromatic diamines defined by the following formula (5) other than the siloxane type diamine and the fluorene type diamine, it becomes easy to properly adjust the glass transition temperature of the polyimide resin in a proper range of the invention and it is preferable. Further, in the case the polyimide resin is used for a laminate film comprising a heat resistant insulation film and the polyimide resin laminated thereon or for a metal layer-bearing laminate film comprising the laminate film and a metal layer laminated on the heat resistant resin layer of the film, high adhesiveness and heat resistance can be obtained and therefore, it is preferable. 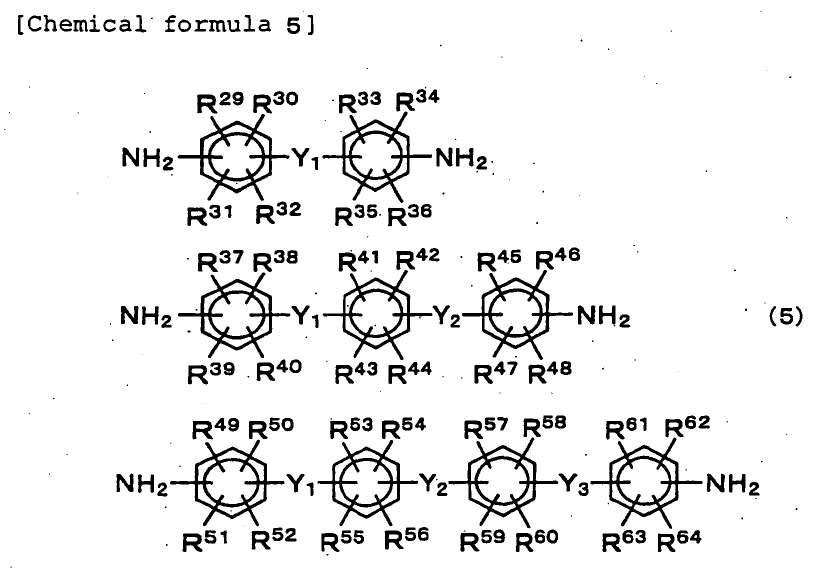 (Y₁ to Y₃ may be same or different and selected from O, CO, S, SO, SO₂, CH₂, C(CH₃)₂, and C(CF₃)₂; R²⁹ to R⁶⁴ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group).
The content of the residual group of the aromatic diamine defined by the formula (5) is 0.1 to 94% by mole, preferably 0.5 to 70% by mole, and more preferably 1 to 50% by mole in the total diamine residual groups. If the content exceeds 94% by mole or higher, the solubility of the polyimide resin in an organic solvent may be decreased.

Practical examples of the aromatic diamines defined by the formula (5) may be 4,4'-diaminodiphenyl ether,
3,3'-diaminodiphenyl ether, 3,4'-diaminodiphenyl ether,
4,4'-diaminodiphenyl sulfone, 3,3'-diaminodiphenyl sulfone,
3,3'-diaminodiphenylmethane, 4,4'-diaminodiphenylmethane,
4,4'-diaminodiphenyl sulfide, 3,3'-diaminobenzopheneone,
3,4'-diaminobenzopheneone, 4,4'-diaminobenzopheneone,
3,3'-dimethyl-4,4'-diaminodiphenylmethane,
1,3-bis(4-aminophenoxy)benzene,
1,3-bis(3-aminophenoxy)benzene,
1,4-bis(4-aminophenoxy)benzene,
4,4'-bis(4-aminophenoxy)biphenyl,
2,2-bis[4-(4-aminophenoxy)phenyl]propane,
2,2-bis[4-(3-aminophenoxy)phenyl]propane,
bis[4-(4-aminophenoxy)phenyl]methane,
bis[4-(3-aminophenoxy)phenyl]methane,
bis[4-(4-aminophenoxy)phenyl] ether,
bis[4-(3-aminophenoxy)phenyl] ether,
bis[4-(4-aminophenoxy)phenyl] sulfone,
bis[4-(3-aminophenoxy)phenyl] sulfone, and
2,2-bis[4-(4-aminophenoxy)phenyl]hexafluoropropane. These aromatic diamines may be used alone or two or more of them may be used in form of a mixture.

Among the aromatic diamines defined by the above-mentioned formula (5) are preferably used 4,4'-diaminodiphenyl ether, 3,4'-diaminodiphenyl ether, 4,4'-diaminodiphenyl sulfone, 4,4'-diaminodiphenylmethane, 1,3-bis(4-aminophenoxy)benzene, 1,3-bis(3-aminophenoxy)benzene, and 1,4-bis(4-aminophenoxy)benzene.

In the invention, besides the above-mentioned diamines, other aliphatic diamines, cyclic hydrocarbon-containing alicyclic diamines, and aromatic diamines may be added to an extent that the properties such as organic solvent-solubility and heat resistance are not adversely affected.

Practical examples are 1,3-diaminocyclohexane,
1,4-diaminocyclohexane, 4,4'-methylenebis(cyclohexylamine),
3,3'-methylenebis(cyclohexylamine),
4,4'-diamino-3,3'-dimethyldicyclohexylmethane,
4,4'-diamno-3,3'-dimethyldicylcohexyl, p-phenylenediamine,
m-phenylenediamine, 2,5-diaminotoluene, 2,4-diaminotoluene,
3,5-diaminobenzoic acid, 2,6-diaminobenzoic acid,
2-methoxy-1,4-phenylenediamine, 4,4'-diaminobenzanilide,
3,4'-diaminobenzanilide, 3,3'-diaminobenzanilide,
3,3'-dimethyl-4,4'-diaminobenzanilide, benzidine,
2,2'-dimethylbenzidine, 3,3'-dimethylbenzidine,
3,3'-dimethoxybenzidine, 2,4-diaminopyridine,
2,6-diaminopyridine, 1,5-diaminonaphthalene,
2,7-diaminofluorene, p-aminobenzylamine, m-aminobenzylamine,
1,3-bis[3-(4-aminophenoxy)phenoxy]benzene, and
1,3-bis[3-(3-aminophenoxy)phenoxy]benzene.

It is preferable that the soluble polyimide resin contains at least one residual group of tetracarboxylic acid dianhydride having a bent structure in the molecule and defined by the formula (3). The content is preferably 40% by mole, more preferably 60% by mole, and even more preferably 70% by mole in the entire tetracarboxylic acid dianhydride residual groups. 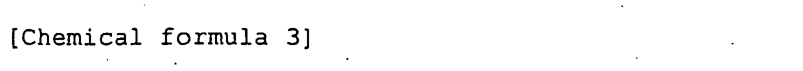 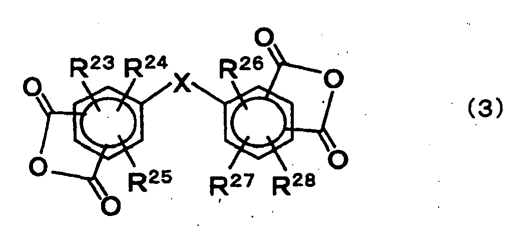 (X is selected from O, CO, S, SO, CH₂, C(CH₃)₂, and C(CF₃)₂; R²³ to R²⁸ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group).
If the residual group of the tetracarboxylic acid dianhydride defined by the.formula (3) is added, the organic solvent-solubility of the polyimide resin becomes excellent and a laminate film obtained by laminating the polyimide resin and a metal layer-bearing laminate film obtained by laminating a metal foil on the laminate film are provided with high adhesiveness.

Practical examples of the tetracarboxylic acid dianhydride defined by the formula (3) are 3,3',4, 4' -diphenyl ether tetracarboxylic acid dianhydride, 2,3,3',4'-diphenyl ether tetracarboxylic acid dianhydride, 2,2',3,3'-diphenyl ether tetracarboxylic acid dianhydride, 3,3',4,4'-benzophenone tetracarboxylic acid dianhydride, 2,2',3,3'-benzophenone tetracarboxylic acid dianhydride, 2,3,3',4'-benzophenone tetracarboxylic acid dianhydride, 3,3',4,4'-diphenylsulfoxide tetracarboxylic acid dianhydride, 3,3',4,4'-diphenylsulfide tetracarboxylic acid dianhydride, 3,3',4,4'-diphenylmethylene tetracarboxylic acid dianhydride, 4,4'-isopropylidenediphthalic acid anhydride, and 4,4'-(hexafluoroisopropylidene)diphthalic acid anhydride. The above-mentioned tetracarboxylic acid dianhydrides may be used alone or two or more of them may be used in form of a mixture.

Among the tetracarboxylic acid dianhydrides defined by the formula (3) are preferably used tetracarboxylic acid dianhydrides in which X of the formula is O such as 3,3',4,4'-diphenyl ether tetracarboxylic acid dianhydride, 2,3,3',4'-diphenyl ether tetracarboxylic acid dianhydride, and 2,2',3,3'-diphenyl ether tetracarboxylic acid dianhydride.

Further, the soluble polyimide resin of the invention is preferable to contain at least one residual group of a tetracarboxylic acid dianhydride having a biphenyl skeleton defined by the formula (4). The content is preferably 30% by weight, more preferably 50% by weight, and even more preferably 70% by weight in the entire tetracarboxylic acid dianhydride residual groups. 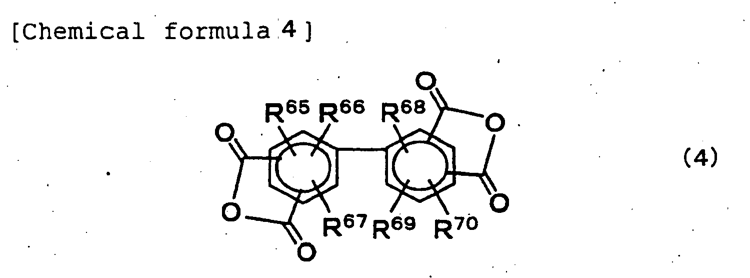 (R⁶⁵ to R⁷⁰ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group).
Addition of the residual group of the tetracarboxylic acid dianhydride defined by the formula (4) improves the organic solvent-solubility of the polyimide resin and the soldering heat resistance of the laminate film comprising the laminated polyimide resin and the metal layer-bearing laminate film comprising the laminate film and a metal foil laminated thereon.

Practical examples of the tetracarboxylic acid dianhydrides defined by the formula (4) are 3,3',4,4'-biphenyltetracarboxylic acid dianhydride, 2,3,3',4'-biphenyltetracarboxylic acid dianhydride, 2,2',3,3'-biphenyltetracarboxylic acid dianhydride, 2,2'-dimethyl-3,3',4,4'-biphenyltetracarboxylic acid dianhydride, and 5,5'-dimethyl-3,3',4,4'-biphenyltetracarboxylic acid dianhydride. These tetracarboxylic acid dianhydrides may be used alone or two or more of them may be used in form of a mixture.

In the invention, if the tetracarboxylic acid dianhydride defined by the formula (3) and the tetracarboxylic acid dianhydride defined by the formula (4) are used while being copolymerized each other, both of the adhesiveness and the heat resistance can be improved and therefore it is more preferable. In this case, the copolymerization ratio is in a range from (9 : 1) to (1 : 9), more preferably from (4 : 1) to (1 : 4) and even more preferably from (7 : 3) to (3 : 7). In this case, the total content of the residual group of the tetracarboxylic acid dianhydride defined by the formula (3) and the residual group of the tetracarboxylic acid dianhydride defined by the formula (4) is preferably 40% by mole or higher, more preferably 60% by mole or higher, and even more preferably 70% by mole or higher in the entire tetracarboxylic acid dianhydride residual groups.

The soluble polyimide resin of the invention may contain another tetracarboxylic acid dianhydride besides the above-mentioned tetracarboxylic acid dianhydrides to an extent that properties such as the organic solvent solubility and the heat resistance are not adversely affected. Practical examples are pyromellitic acid dianhydride, 3,3',4,4'-diphneylsulfonetetracarboxlic acid dianhydride, 2,3,3',4'-diphenylsulfonetetracarboxylic acid dianhydride, 3,4,9,10-perilenetetracarboxylic acid dianhydride, 2,3,6,7-naphthalenecarboxylic acid dianhydride, 1,4,5,8-naphthalenetetracarboxylic acid dianhydride, 1,2,5,6-naphthalenetetracarboxylic acid dianhydride, 3,3",4,4"-p-terphenylcarboxylic acid dianhydride, 3,3",4,4"-m-terphenylcarboxylic acid dianhydride, 2,3,6,7-anthracenetetracarboxylic acid dianhydride, 1,2,7,8-phenanethrenetetracarboxylic acid dianhydride, 2,3,5-tricarboxycyclopentylacetic acid dianhydride, 1,2,3,4-cyclobutanetetracarboxylic acid dianhydride, 1,2,3,4-cyclopentanetetracarboxylic acid dianhydride, 1,2,3,5-cyclopentanetetracarboxylic acid dianhydride, 1,2,4,5-bicyclohexenetetracarboxylic acid dianhydride, 1,2,4,5-cyclehexanetetracarboxylic acid dianhydride, 1,3,3a,4,5,9b-hexahydro-5-(tetrahydro-2,5-dioxo-3-furanyl)-naphtho[1,2-C]furane-1,3-dione.

In the case of producing the polyimide resin of the invention, he mole ratio of tetracarboxylic acid/diamine is generally adjusted to be 100/100 and in the case the viscosity of the resin solution becomes too high, the mole balance of the tetracarboxylic acid/diamine may be adjusted to be unbalance between the tetracarboxylic acid and the diamine in a range of 100/(95 to 100) or in a range of (95 to 100)/100, so that the viscosity of the resin solution can be controlled to be in a range with no adverse effect on the coatability or the like. However, if the mole balance is made unbalance, the molecular weight of the resin may be lowered and a formed film or a molded body is deteriorated in the mechanical strength. For example, in the case the polyimide resin is used for an adhesive layer of the metal layer-bearing laminate film, the adhesiveness to the metal layer or the heat resistant insulation film also tends to be lowered, it is preferable to adjust the mole ratio to an extent that the adhesiveness is not weakened.

In the case the amount of the tetracarboxylic acid or the diamine is made excess, the polymer chain terminals may be sealed with a terminal sealing agent of such as an acid component or an amine component. Preferable examples to be used as the terminal sealing agent of the acid component may be benzoic acid and dicarboxylic acids and their anhydride such as phthalic anhydride and tetrachlorophthalic anhydride. Preferable examples to be used as the terminal sealing agent of the amine component may include monoamine such as aniline. In this case, it is preferable to adjust to be equimolecular between the acid equivalent of the tetracarboxylic acid component including the acid component of the terminal sealing agent and the amine equivalent of the diamine component including the amine component of the terminal sealing agent.

A method of synthesizing the soluble polyimide resin of the invention is not particularly limited. For example, conventionally known methods such as a thermal imidation method, a chemical imidation method, and a diisocyanate method can be used.

In the thermal imidation method, at first a tetracarboxylic acid dianhydride and a diamine are stirred in an organic solvent at a temperature in a range from a room temperature to 100°C for 1 to 100 hours to carry out polymerization and form a polyamide acid. Thereafter, the temperature is increased to 120 to 300°C and stirring is carried out for 1 to 100 hours to heat and dehydrate the polyamide acid to convert the polyamide acid into a polyimide. At that time, toluene, o-xylene, m-xylene, or p-xylene may be added to the reaction solution to remove the water produced in the imidation reaction with the solvent by azeotropic boiling.

In the chemical imidation method, at first a tetracarboxylic acid dianhydride and a diamine are stirred in an organic solvent at a temperature in a range from a room temperature to 200°C while an imidation catalyst such as acetic anhydride, trifluoroacetic anhydride, or p-hydroxyphenylacetic anhydride is added with pyridine, picoline, imidazole, quinoline, or triethylamine. The imidation catalyst may be added alone.

In the diisocyanate method, a tetracarboxylic acid dianhydride and a diisocyanate in place of a diamine are heated in an organic solvent at 80 to 300°C to carry out reaction and form a polyimide accompanied with decarbonation.

The solvent to be used for the synthesis of the soluble polyimide resin of the invention may be amide type polar solvents such as N-methyl-2-pyrrolidone, N,N-dimethylacetamide, N,N-diethylacetamide, N,N-dimethylformamide, N,N-diethylformamide, and N-methylcaprolactam; lactone type polar solvents such as β-propiolactone, γ-butyrolactone, γ-valerolactone, δ-valerolactone, γ-caprolactone, and ε-caprolactone; and N,N,N',N'-tetramethylurea, dimethyl sulfoxide, ethyl lactate, butyl lactate, phenol, o-cresol, m-cresol, p-cresol, methyl carbitol, ethyl carbitol, diethylene glycol dimethyl ether, and diethylene glycol diethyl ether. These solvents may be used alone or two ore more of them may be used in form of a mixture.

The concentration of the polyimide at the time of synthesis is 5 to 60% by weight and preferably 10 to 40% by weight.

The polyimide solution obtained by the above-mentioned method may be used as it is or a polyimide powder may be precipitated by pouring the solution in a bad solvent such as water, methanol, ethanol, isopropyl alcohol, acetone, toluene, xylene, or the like. The use amount of these bad solvents is not particularly limited, however it is about 5 to 100 times, preferably 10 to 50 times, as much as that of the solvent used for the synthesis. The precipitated polyimide powder is filtered, washed, and dried.

In the invention, the obtained polyimide powder is dissolved again in an organic solvent to use the powder in form of a polyimide solution. A solvent to be used at that time may be amide type polar solvents such as N-methyl-2-pyrrolidone, N,N-dimethylacetamide, N,N-diethylacetamide, N,N-dimethylformamide, N,N-diethylformamide, and N-methylcaprolactam; lactone type polar solvents such as β-propiolactone, γ-butyrolactone, γ-valerolactone, δ-valerolactone, γ-caprolactone, and ε-caprolactone; and N,N,N',N'-tetramethylurea, dimethyl sulfoxide, ethyl lactate, butyl lactate, phenol, o-cresol, m-cresol, p-cresol, methyl carbitol, ethyl carbitol, diethylene glycol dimethyl ether, diethylene glycol diethyl ether, dioxane, tetrahydrofuran, acetonitrile, methyl cellosolve, ethyl cellosolve, methyl cellosolve acetate, and ethyl cellosolve acetate. These solvents may be used alone or two ore more of them may be used in form of a mixture.

In the invention, it is preferable to use a solvent selected from N-methyl-2-pyrrolidone, N,N-dimethylacetamide, N,N-diethylacetamide, N,N-dimethylformamide, N,N-diethylformamide, N,N,N',N'-tetramethylurea, dimethyl sulfoxide, and γ-butyrolactone as the solvent.

The polyimide resin of the invention may be used in form of a composition by adding other resins and fillers to an extent that the effects of the invention are not adversely affected. Examples of other resins may be heat resistant polymer resins such as acrylic resins, acrylonitrile resins, butadiene type resins, urethane type resins, polyester type resins, polyamide type resins, polyamide imide type resins, epoxy type resins, and phenol type resins. The fillers include organic or inorganic fine particles and fillers. Practical examples of the fine particles and fillers are silica, alumina, titanium oxide, quartz powder, magnesium carbonate, potassium carbonate, barium sulfate, mica, and talc.

The polyimide resin of the invention can be used in an electronic industrial field for a liquid crystal oriented film, a sealing agent, a protection film, an adhesive for a multilayer substrate, and an adhesive for an FPC and all other fields and particularly it is preferably used as an adhesive for an FPC. In the case of using it as an adhesive for a FPC, it is used in form of a laminate film comprising a heat resistant resin layer functioning as an adhesive layer containing the polyimide resin of the invention in one face or both faces of a heat resistant insulation film, or a metal layer-bearing laminate film comprising a metal layer further on a heat resistant resin layer of the laminate film.

The heat resistant insulation film to be used for the laminate film or the metal layer-bearing laminate film of the invention is a film made of a heat resistant polymer. Examples of preferable heat resistant polymers are aromatic polyimide type resin, polyphenylene sulfide type resin, aromatic polyamide type resin, polyamide imide type resin, and aromatic polyester type resin and practical products are Kapton (registered trademark, manufactured by Du Pont - Toray Co., Ltd.), Upilex (registered trademark, manufactured by Ube Industries, Ltd.), Apical (registered trademark, manufactured by Kanegafuchi Chemical Industry Co., Ltd.), Mictron (registered trademark, manufactured by Toray Co., Ltd.), and Vecster (registered trademark, manufactured by Kuraray Co., Ltd.). Among them is preferably used the aromatic type polyimide resin.

The thickness of the heat resistant insulation film is not particularly limited and it is preferably 3 to 150 µm, more preferably 5 to 75 µm, and even more preferably 10 to 50 µm. If it is thinner than 3 µm, the strength as a support may be possibly insufficient. On the other hand, if it exceeds 150 µm, the flexibility is lowered and bending may be possibly difficult.

One face or both faces of the heat resistant insulation film to be used in the invention are preferable to be subjected to adhesiveness improvement treatment based on the purposes.

The adhesiveness improvement treatment may include treatment for making the surface of a film physically uneven by sand blast or wet blast by jetting at a high speed a dispersion containing fine particles such as glass beads dispersed in water or the like; treatment for making the surface of a film chemically uneven by a permanganic acid solution or an alkaline solution; electric discharge treatment such as normal pressure plasma treatment, corona electric discharge treatment, and low temperature plasma treatment. In the invention, electric discharge treatment such as normal pressure plasma treatment, corona electric discharge treatment, and low temperature plasma treatment is carried out preferably for the adhesiveness improvement treatment.

The normal pressure plasma treatment is a method for carrying out electric discharge treatment in atmosphere of Ar, N₂, He, CO₂, CO, air, or steam. The treatment conditions differ depending on a treatment apparatus, the type of a treatment gas, the flow rate, and the frequency of a power source and proper and optimum conditions may be selected.

The low temperature plasma treatment can be carried out in reduced pressure and its method is not particularly limited. A preferable method is carried out, for example, by setting an object substrate to be treated in an inner electrode type electric discharge treatment apparatus having coupled polar electrodes comprising a drum type electrode and a plurality of rod-like electrodes; generating electric discharge by applying d.c. or a.c. high voltage between the electrodes in the state that a treatment gas is adjusted at 1 to 1000 Pa and preferably 5 to 100 Pa for generating plasma of the treatment gas; and exposing the substrate surface to the plasma. The conditions of the low temperature plasma treatment differ depending on a treatment apparatus, the type and the pressure of the treatment gas, and the frequency of a power source and proper and optimum conditions may be selected. For example, Ar, N₂, He, CO₂, CO, air, steam, O₂, CF₄ may be used alone or while being mixed as the treatment gas.

Corona electric discharge treatment may be employed, however in the case the corona electric discharge treatment is employed, the effect on the adhesiveness improvement is sometimes low as compared with the low temperature plasma treatment and therefore, it is preferable to select treatment which makes the heat resistant resin layer to be laminated easy to be stuck.

The metal layer of the metal layer-bearing laminate film of the invention may be formed by metal foil lamination, vacuum deposition, sputtering, ion plating, electroless plating, or electric plating alone or combining two or more of these methods. In the invention, in terms of the productivity and the production cost, it is preferable to produce the metal layer-bearing laminate film by forming the metal layer by a laminate method involving sticking a metal foil to the heat resistant resin layer side of the laminate film and heating and pressure-bonding the metal foil.

The metal layer of the invention is formed using the metal foil such as a copper foil, an aluminum foil, or a SUS foil and normally, a copper foil is used. The copper foil includes an electrolytic copper foil and a rolled copper foil and both foils may be employed.

Hereinafter, the copper foil is employed as an example for explanation, however it is only an example and any other metal foil may be used in the same manner as well.

The copper foil may be subjected to roughening treatment in the adhesion face side. Both faces of the copper foil are generally separately called S face (luster face) and M face (coarsened face) and in the case a resin is to be formed, the resin is stuck normally to the M face side. Accordingly, the roughening treatment is often carried out normally in the M face side. In the case the resin is stuck to both face of the copper foil, both of the S face and the M face may be surface-roughened. Herein, the roughening treatment is process of forming an uneven surface by depositing copper fine particles with a size of 1 to 5 µm on one face or both faces of a starting foil on which a film is formed by electroplating.

As a wiring pattern of an FPC has been being finer, it is preferable that the unevenness of the copper foil surface is made smaller not only in the S face but also in the M face and the copper foil smooth in both faces which are not subjected to roughening treatment is more preferable. The roughness of the copper foil surface is preferably 0.5 µm or lower and more preferably 0.4 µm or lower on the basis of Ra (the arithmetical mean deviation) and preferably 2.0 µm or lower and more preferably 1.8 µm or lower on the basis of Rz (ten-point average roughness) for the S face. It is also is preferably 0.7 µm or lower and more preferably 0.5 µm or lower, and even more preferably 0.4 µm or lower on the basis of Ra and preferably 3.0 µm or lower, more preferably 2.0 µm or lower, and even more preferably 1.8 µm or lower on the basis of Rz for the M face.

The thickness of the copper foil is preferably in a range from 1 to 150 µm and may be properly selected based on the uses. As a wiring pattern of an FPC has been being finer, it is preferable that the thickness of the copper foil is made thinner. However since it becomes more difficult to handle the foil as a single substance if the copper foil is made thinner, the copper foil with a thickness of 3 µm to 5 µm is handled in form of a carrier-bearing copper foil obtained by sticking the copper foil to a support (carrier) of a resin or a metal foil with a thickness about 20 to 50 µm and after the foil is heated and pressure-bonded to a resin, the support is separated. The thickness of the copper foil in the invention is preferably 20 µm or thinner, more preferably 15 µm or thinner, and even more preferably 10 µm or thinner. The thickness of the copper foil in the invention is preferably 1 µm or thicker, more preferably 3 µm or thicker, and even more preferably 5 µm or thicker.

The copper foil may be subjected to anti-rust treatment for discoloration prevention. The anti-rust treatment is generally carried out by layering a thin film layer of such as nickel, zinc, or a chromium compound on the copper foil surface. Further, to improve the adhesiveness to a resin, the copper foil surface may be treated with a silane coupling agent.

The glass transition temperature of the heat resistant resin layer of the laminate film or the metal layer-bearing laminate film of the invention is in a range from 200 to 320°C, preferably from 220 to 300°C, and even more preferably from 240 to 280°C. If the glass transition temperature of the heat resistant resin layer is lower than 200°C, it causes a problem of mechanical heat resistance that the wiring subsides in the heat resistant resin layer in the bonding of an IC or pressing at a high temperature. If the glass transition temperature exceeds 320°C, the adhesiveness to the metal layer is lowered.

Various measurement methods may be used for measuring the glass transition temperature of the heat resistant resin layer of the invention. For example, a measurement method (DSC method) using a differential scanning calorimetric apparatus, a measurement method (TMA method) using a thermomechanical analyzer, and a dynamic modulus measurement method (DMA method) using a dynamic thermomechanical measurement apparatus. In the case of DMA method, the peak maximum value of tan δ is defined as the glass transition temperature.

A production method of the laminate film and the metal layer-bearing laminate film of the invention will be described with reference to examples.

A polyimide resin composition of the invention is applied to one face or both faces of a heat resistant insulation film such as a polyimide film by a bar coater, a roll coater, a knife coater, a comma coater, a reverse coater, a doctor blade float coater, a gravure coater, or a slit die coater and the solvent contained in the polyimide resin composition is removed by continuously or intermittently heating at 60 to 250°C for 1 to 60 minutes to obtain a laminate film. The thickness of the heat resistant resin layer is preferably 0.2 to 12 µm, more preferably 0.5 to 10 µm, and even more preferably 1 to 7 µm after the drying. The amount of the remaining solvent in the heat resistant resin layer is preferably 10% by weight or lower, more preferably 5% by weight or lower, and 2% by weight or lower. If the remaining solvent amount is high, after the laminate film is rolled, the neighboring turns of the laminate film are firmly stuck to each other to make unrolling impossible or foaming occurs in the heat resistant resin layer at the time of laminating a metal layer.

Next, a metal foil such as a copper foil is stuck to the heat resistant resin layer of the obtained laminate film and heated and pressure-bonded to obtain the metal layer-bearing laminate film.

The heating and pressure-bonding is carried out using a heat press or a heating roll laminator. Since the heating roll laminator is usable for continuous heating and pressure-bonding of a long film or metal foil, it is preferably usable in terms of the productivity. Schematic drawings showing the heating and pressure-bonding process by a heat roll laminator are illustrated in Fig. 1 and Fig. 2. As shown in the drawings, the heat roll laminator is provided with one or more pairs of heating rolls 1 and 2. A metal foil 8 unrolled out of a metal foil-unrolling roll 3 and a laminate film 9 unrolled out of a laminate film-unrolling roll 4 are passed through the heating rolls to heat and pressure-bond them. The obtained metal layer-bearing laminate film is rolled on a product rolling roll 5. Herein, Fig. 1 and Fig. 2 are schematic drawings showing the production of a laminate film bearing a metal layer on one face and the production of a laminate film bearing a metal layer on both faces, respectively.

The rolls to be employed for the heating roll laminator may be combinations of a metal roll with a metal roll, a metal roll with a rubber roll, and a rubber roll with a rubber roll. Generally, in the case of producing the laminate film bearing a metal layer on one face, a combination of a metal roll with a rubber roll is employed and in the state that the metal foil is set in the metal roll side and the heat resistant insulation film is set in the rubber roll side, heating and pressure-bonding is carried out. However, in the case the roll temperature is 200°C or higher, the combination of a metal roll with a metal roll is preferable to be used. In the case of producing the laminate film bearing a metal layer on both faces, a combination of a metal roll with a rubber roll is employed.

The conditions such as the roll temperature, the roll nip pressure, and.the transportation speed of the heating roll laminator are properly selected depending on the type, the composition, and the production method of the heat resistant resin layer. Generally, the roll temperature is set to be preferably 50 to 500°C, more preferably 100 to 450°C, and even more preferably 150 to 400°C. Heating with rolls may be carried out using rolls of which only one is usable for heating, however use of both rolls which are usable for heating is preferable. It is more preferable that both rolls are usable for heating. It is further more preferable that both rolls are usable for heating and they are independently controllable in heating. The roll nip pressure of the heating roller laminator is, in general, set in a range preferably from 0.5 to 200 N/mm, more preferably from 2 to 150 N/mm, and even more preferably from 5 to 100 N/mm. The transportation speed is, in general, set in a range preferably from 0.1 to 50 m/min, more preferably from 0.4 to 30 m/min, and even more preferably from 1 to 10 m/min.

In the case of lamination at a roll temperature of 300°C or higher, to prevent oxidation of the metal foil such as the copper foil, it may be carried out in nitrogen atmosphere or vacuum. Further, in the heating and pressure-bonding process, as shown in Fig. 3 and Fig. 4, a protection film 10 may be inserted between the metal foil 3 and the heating rolls 1 and 2 or the laminate film 4 and the heating rolls 1 and 2. As the protection film, the heat resistant resin film such as a polyimide film or a metal foil of SUS or aluminum can be used. The protection film 10 is unrolled out of a protection film-unrolling roll 6 and passed through the heating rolls 1 and 2 together with the metal foil 3 and the laminate film 4 and then rolled on a protection film rolling roll 7. Herein, Fig. 3 shows the schematic drawing showing the case of producing the laminate film bearing the metal layer in one face and Fig. 4 shows the schematic drawing showing the case of producing the laminate film bearing the metal layer in both faces.

In the invention, after the laminate film and the metal foil are heated and pressure-bonded, heating treatment may be carried out again. In this case, the heating treatment may be carried out by batch type treatment in which the metal layer-bearing laminate film is rolled, continuous treatment in a roll-to-roll manner, or sheet treatment of cut sheets. The" heat treatment is carried out at a temperature in a range preferably from 200 to 400°C, more preferably from 240 to 350°C, and even more preferably from 260 to 320°C for 1 to 48 hours. The temperature may be increased step by step to an aimed temperature. Further, in order to prevent oxidation of the metal layer, the treatment is preferable to be carried out in vacuum or nitrogen atmosphere.

The metal layer of the metal layer-bearing laminate film is pattern-wise processed to form a wiring pattern and accordingly to produce an FPC substrate. The pitches of the wiring pattern is not particularly limited, however they are preferably in a range from 10 to 150 µm, more preferably from 15 to 100 µm, and even more preferably from 20 to 80 µm.

A semiconductor device of the invention comprises the above-mentioned FPC substrate and IC mounted on the substrate. The semiconductor device is used for a driver IC or the like in a liquid crystal display. The semiconductor device of the invention is fabricated in a COF manner or a TAB (Tape Automated Bonding) manner.

As one example of a semiconductor device fabrication method by mounting IC, a fabrication method in a COF manner employing a flip chip technique will be described.

The metal layer-bearing laminate film of the invention is slit in an aimed width. Next, a photoresist film is applied to the metal layer of the metal layer-bearing laminate film and a wiring pattern is formed by exposure through a mask. After that, the metal layer is wet etched and the remaining photoresist film is removed to form the metal wiring pattern. After the formed metal wiring pattern is plated with tin or gold in a thickness of 0.2 to 0.8 µm, a solder resist is applied to the wiring pattern to obtain a COF tape.

An IC having a gold bump bonded with an inner lead of the COF tape obtained in the above-mentioned manner is mounted by the flip chip mounting method and potted with a resin to obtain the semiconductor device of the invention.

A mounting method of the IC may include a metal joining method of gang bonding a bump of the IC with the wiring; a wire-bonding method of joining a joining part of the IC and an inner lead of the COF tape with a wire bond; an ACF method of carrying out joining with an adhesive film containing a conductive filler in an adhesive layer; and an NCP method of carrying out joining using a non-conductive adhesive. The ACF method and the NCP method are capable for carrying out joining at a relatively low temperature, however in terms of the connection reliability, generally the metal joining method, particularly a joining method employing a gold-tin eutectic crystal formation, has been used widely.

In the joining based on the gold-tin eutectic crystal formation, to absorb the unevenness of the height of the bump in the IC side and the wiring in the wiring side, a load of 20 to 30 g per 1 bump is applied. To form the eutectic crystal of gold and tin and carry out joining with high reliability, temperature is generally required to be 280°C or higher and therefore, the temperature of the joining face is generally set to be 300 to 400°C.

### [Examples]

Hereinafter, the invention will be described with reference to Examples, however it is not intended that the invention be limited to the illustrated Examples. The measurement methods of solubility in an organic solvent, a glass transition temperature, the adhesion strength, a gold-tin bonding durability, and soldering heat resistance will be described.

### (1) Solubility in organic solvent

A polyimide powder was added in an amount of 10% by weight, 15% by weight, and 20% by weight on the basis of solid matter concentration in DMAc (N,N-dimethylacetamide) or NMP (N-methyl-2-pyrrolidone) and stirred at a room temperature for 1 hour and successively kept still for a 3 hours and the resulting state was observed with eyes. In the case the polyimide powder was dissolved and no insoluble polyimide resin was observed, the grade A was given in Table 1 and Table 2. In the case gelation occurred after dissolution, the grade B was given and in the case insoluble polyimide resin was observed, the grad C was marked.

### (2) Measurement of glass transition temperature

After a polyimide resin solution was applied in a prescribed thickness to a luster face of an electrolytic copper foil with a thickness of 18 µm, the solution was dried at 80°C for 10 minutes and at 150°C for 10 minutes and further heated at 280°C in nitrogen atmosphere for 1 hour to obtain a laminate film of the electrolytic copper foil and the heat resistant resin layer. Next, the entire face of the electrolytic copper foil of the laminate film was etched with a ferric chloride solution to form a single film of the heat resistant resin.

The obtained single film of the heat resistant resin in an amount of about 10 mg was packed in a standardized container made of an aluminum and subjected to the measurement method (DSC method) using a differential scanning calorimeter DSC-50 (manufactured by Shimadzu Corporation) and the glass transition temperature was calculated from the inflection point of the obtained DSC curve. The DSC measurement method was carried out after preliminary drying of a sample in condition of 80°C × 1 hour and successively heating at 20°C/min heating rate.

### (3) Measurement of adhesion strength (steady state)

The copper layer of each copper layer-bearing laminate film obtained in respective Examples was etched in 2 mm width with a ferric chloride solution. The peeling strength measured by pulling the copper layer with 2 mm thickness at 50 mm/min pulling speed by TENSILON UTM-4-100, manufactured by TOYO BOLDWIN and peeling the layer in the direction at 90° to the laminate film and the measured value was employed as the adhesion strength.

### (4) Gold-tin bonding durability

After a positive type resist 300 RH manufactured by Tokyo Ohka Kogyo Co., Ltd. was applied properly to give a thickness of 4 µm after drying to the copper layer surface of the copper layer, the resist was exposed through a mask having a pattern for bonding and a wiring pattern for bonding was formed in the resist film using a development solution PMER P-1S manufactured by Tokyo Ohka Kogyo Co., Ltd. Using the resulting resist pattern as mask, the copper layer was etched with a ferric chloride solution and the resist film was removed with an aqueous alkaline solution to form a copper wiring pattern with 200 bonding parts.

Using a flip chip bonder FC 2000 manufactured by Toray Engineering Co., Ltd. and setting the stage temperature at 80°C, a load to be 40 N, pushing time for 3 seconds, and the temperature of the joining interface in the tool side to be 300°C, an IC chip having 200 pins of gold bumps was aligned to carry out bonding to the copper layer-bearing laminate film on which the wiring pattern was formed. After the IC chip was removed, the subsidence state of the wiring in the joined part in the heat resistant resin layer and the peeling of the wiring in the peripheral part of the joined part were observed using SEM and evaluated.

### (5) Soldering heat resistance

Each copper layer-bearing laminate film obtained in the respective Examples was cut into a size of 20 × 40 mm to obtain a specimen. After the specimen was left in a high temperature and high humidity oven under conditions of 40°C and 90% RH for 24 hours, the specimen was floated in a solder bath for 1 minute and whether appearance change such as blister of the copper layer occurs or not was observed with eyes and the highest temperature of the solder bath at the time when no appearance change was caused was defined as the temperature of soldering heat resistance of the specimen.

The acid dianhydrides and diamines shown in the following Production Examples are abbreviated as the following names: OPDA: 3,3',4,4'-diphenyl ether tetracarboxylic acid dianhydride
DSDA: 3,3',4,4'-diphenyl sulfone tetracarboxylic acid dianhydride
BPDA: 3,3',4,4'-diphenyl tetracarboxylic acid dianhydride
SiDA: 1,1,3,3-tetramethyl-1,3-bis(3-aminopropyl)disiloxane
FDA: 9,9-bis(4-aminophenyl)fluorene
44DAE: 4,4'-diaminodiphenyl ether
34DAE: 3,4'-diaminodiphenyl ether
PDA: p-phenylenediamine
BAB: 1,3-bis(4-aminophenoxy)benzene
APB: 1,3-bis(3-aminophenoxy)benzene
BAPS: bis[4-(3-aminophenoxy)phenyl]sulfone
DABA: 4,4'-diaminobenzanilide
BAPB: 1,3-bis[3-(4-aminophenoxy)phenoxy]benzene
m-TB: 2,2'-dimethylbendizine
NMP: N-methyl-2-pyrrolidone
DMAc: N,N-dimethylacetamide

### Production Example 1

SiDA 12.4 g (0.05 mol), FDA 104.6 g (0.3 mol), 44DAE 130.1 g (0.65 mol) were loaded together with NMP 3158 g to a reaction vessel equipped with a thermometer, a dry nitrogen introduction inlet, a heating and cooling apparatus using hot water and cold water, and a stirrer and dissolved. After that, OPDA 310. 2 g (1 mol) was added and reaction was carried out at 70°C for 4 hours to polymerize the polyamide acid and obtain a polyamide acid solution in a concentration of 15% by weight. Toluene 500 g was added to the obtained polyamide acid solution and heated at 200°C and while water azeotropically boiled with toluene was removed along with the promotion of the reaction, imidation reaction was carried out for 3 hours. After that, toluene was removed, the obtained polyimide varnish was poured in water and the obtained precipitate was separated, crushed, washed, and dried to obtain a polyimide powder (P1). The solvent solubility of polyimide powder (P1) in DMAc or NMP is shown in Table 1.

### Production Examples 2 to 25

The same process was carried out as in Production Example 1, except the types and the loading amounts of the acid dianhydrides and diamines were changed as shown in Table 1 to obtain polyimide powders (P2 to P25). The solvent solubility of polyimide powders (P2 to P25) in DMAc or NMP is shown in Table 1.

**[Table 1-1]**

| Table 1 | | | | | | | | | | | | | | | | |
|---|---|---|---|---|---|---|---|---|---|---|---|---|---|---|---|---|
| | | | | | | | | | | | Solvent-solubility | | | | | |
| | | Acid component | | Diamine component | | | | | | Solvent | DMAc | | | NMP | | |
| | | OPDA | DSDA | SiDA | FDA | 44DAE | 34DAE | PDA | BAB | NMP | 10% by weight | 15% by weight | 20% by weight | 10% by weight | 15% by weight | 20% by weight |
| Production Example 1 | P1 | 1 | | 0,05 | 0,3 | 0,65 | | | | 3158 | A | A | A | A | A | A |
| | | 310,2 | | 12,4 | 104,6 | 130,1 | | | | | | | | | | |
| Production Example 2 | P2 | 1 | | 0,1 | 0,2 | 0,7 | | | | 3088 | A | A | A | A | A | A |
| | | 310,2 | | 24,9 | 69,7 | 140,1 | | | | | | | | | | |
| Production Example 3 | P3 | 1 | | 0,1 | 0,6 | 0,3 | | | | 3424 | A | A | A | A | A | A |
| | | 310,2 | | 24.9 | 209,1 | 60,1 | | | | | | | | | | |
| Production Example 4 | P4 | 1 | | 0,15 | 0,1 | 0,75 | | | | 3018 | A | A | A | A | A | A |
| | | 310,2 | | 37,3 | 34,9 | 150,2 | | | | | | | | | | |
| Production Example 5 | P5 | 1 | | 0,15 | 0,3 | 0,55 | | | | 3186 | A | A | A | A | A | A |
| | | 310,2 | | 37,3 | 104,6 | 110,1 | | | | | | | | | | |
| Production Example 6 | P6 | 1 | | 0,15 | 0,5 1 | 0,35 | | | | 3424 | A | A | A | A | A | A |
| | | 310,2 | | 37,3 | 74,3 | 70,1 | | | | | | | | | | |
| Production Example 7 | P7 | 1 | | 0,2 | 0,4 | 0,4 | | | | 3283 | A | A | A | A | A | A |
| | | 310,2 | | 49,7 | 139,4 | 80,1 | | | | | | | | | | |
| Production Example 8 | P8 | 1 | | 0,2 | 0,7 | 0,1 | | | | 3535 | A | A | A | A | A | A |
| | | 310,2 | | 49,7 | 244 | 20 | | | | | | | | | | |
| Production Example 9 | P9 | 1 | | 0,25 | 0,4 | 0,35 | | | | 3297 | A | A | A | A | A | A |
| | | 310,2 | | 62,1 | 139,4 | 70,1 | | | | | | | | | | |
| Production Example 10 | P10 | 1 | | 0,25 | 0,6 | 0,15 | | | | 3465 | A | A | A | A | A | A |
| | | 310,2 | | 62,1 | 209,1 | 30 | | | | | | | | | | |
| Production Example 11 | P11 | 1 | | 0,1 | 0,05 | | | | 0,85 | 3406 | A | A | A | A | A | A |
| | | 310,2 | | 24,9 | 17,4 | | | | 248,5 | | | | | | | |
| Production Example 12 | P12 | 1 | | 0,15 | 0,4 | | | | 0,45 | 3504 | A | A | A | A | A | A |
| | | 310,2 | | 37,3 | 139,4 | | | | 131,5 | | | | | | | |
| Production Example 13 | P13 | 1 | | 0,1 | 0,3 | | 0,6 | | | 3172 | A | A | A | A | A | A |
| | | 310,2 | | 24,9 | 104,6 | | 120,1 | | | | | | | | | |
| | | Upper: number of mole; lower loading amount (g) | | | | | | | | | | | | | | |

**[Table 1-2]**

| Continued trom Table 1 | | | | | | | | | | | | | | | | |
|---|---|---|---|---|---|---|---|---|---|---|---|---|---|---|---|---|
| | | | | | | | | | | | Solvent-solubility | | | | | |
| | | Acid component | | Diamine component | | | | | | Solvent | DMAc | | | NMP | | |
| | | OPDA | DSDA | SiDA | FDA | 44DAE | 34DAE | PDA | BAB | NMP | 10% by weight | 15% by weight | 20% by weight | 10% by weight | 15% by weight | 20% by weight |
| Production Example 14 | P14 | 1 | | 0,3 | 0,5 | | | 0,2 | | 3291 | A | B | C | A | A | B |
| | | 310,2 | | 74,6 | 174,3 | | | 21,6 | | | | | | | | |
| Production Example 15 | P15 | | 1 | 0,35 | 0,55 | | 0,1 | | | 3723 | A | A | A | A | A | A |
| | | | 358,3 | 87,0 | 191,7 | | 20 | | | | | | | | | |
| Production Example 16 | P16 | | 1 | 0,25 | 0,2 | 0,55 | | | | 3401 | A | A | A | A | A | A |
| | | | 358,3 | 62,1 | 69,7 | 110,1 | | | | | | | | | | |
| Production Example 17 | P17 | 0,6 | 0,4 | 0,1 | 0,05 | | | | 0,85 | 3514 | A | A | A | A | A | A |
| | | 186,1 | 143,3 | 24,9 | 17,4 | | | | 248,5 | | | | | | | |
| Production Example 18 | P18 | 1 | | | | 1 | | | | 2892 | C | C | C | C | A | C |
| | | 310,2 | | | | 200,2 | | | | | | | | | | |
| Production Example 19 | P19 | 1 | | 0,1 | | | | | 0,9 | 3390 | B | C | C | A | A | C |
| | | 310,2 | | 24,9 | | | | | 263,1 | | | | | | | |
| Production Example 20 | P20 | 1 | | 0,3 | | 0,7 | | | | 2974 | B | C | C | A | A | C |
| | | 310,2 | | 74,6 | | 140,1 | | | | | | | | | | |
| Production Example 21 | P21 | 1 | | | 0,2 | | 0,8 | | | 3061 | A | B | C | A | A | B |
| | | 310,2 | | | 69,7 | | 160,2 | | | | | | | | | |
| Production Example 22 | P22 | 1 | | | 1 | | | | | 3733 | A | A | A | A | A | A |
| | | 310,2 | | | 348,5 | | | | | | | | | | | |
| Production Example 23 | P23 | 1 | | 0,1 | 0,9 | | | | | 3677 | A | A | A | A | A | A |
| | | 310,2 | | 24,9 | 313,7 | | | | | | | | | | | |
| Production Example 24 | P24 | | 1 | 0,1 | 0,85 | 0,05 | | | | 3907 | A | A | A | A | A | A |
| | | | 358,3 | 24,9 | 296,2 | 10 | | | | | | | | | | |
| Production Example 25 | P25 | 1 | | 0,45 | 0,55 | | | | | 3478 | A | A | A | A | A | A |
| | | 310,2 | | 111,8 | 191,7 | | | | | | | | | | | |
| | | Upper number of mole; lower: loading amount (g) | | | | | | | | | | | | | | |

### Production Examples 26 to 52

The same process was carried out as in Production Example 1, except the types and the loading amounts of the acid dianhydrides and diamines were changed as shown in Table 2 to obtain polyimide powders (P26 to P52). The solvent solubility of polyimide powders (P26 to P52) in DMAc or NMP is shown in Table 2.

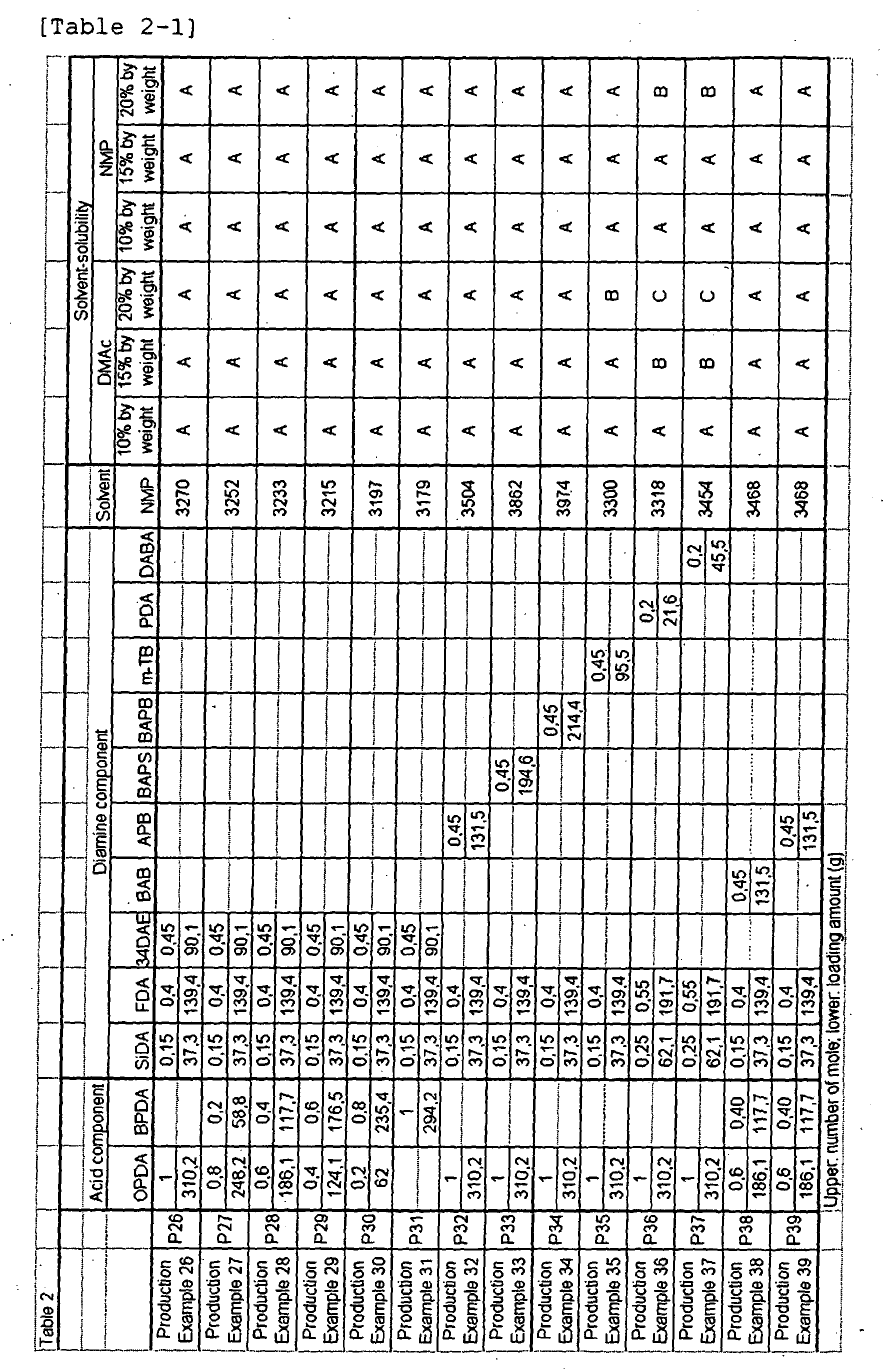

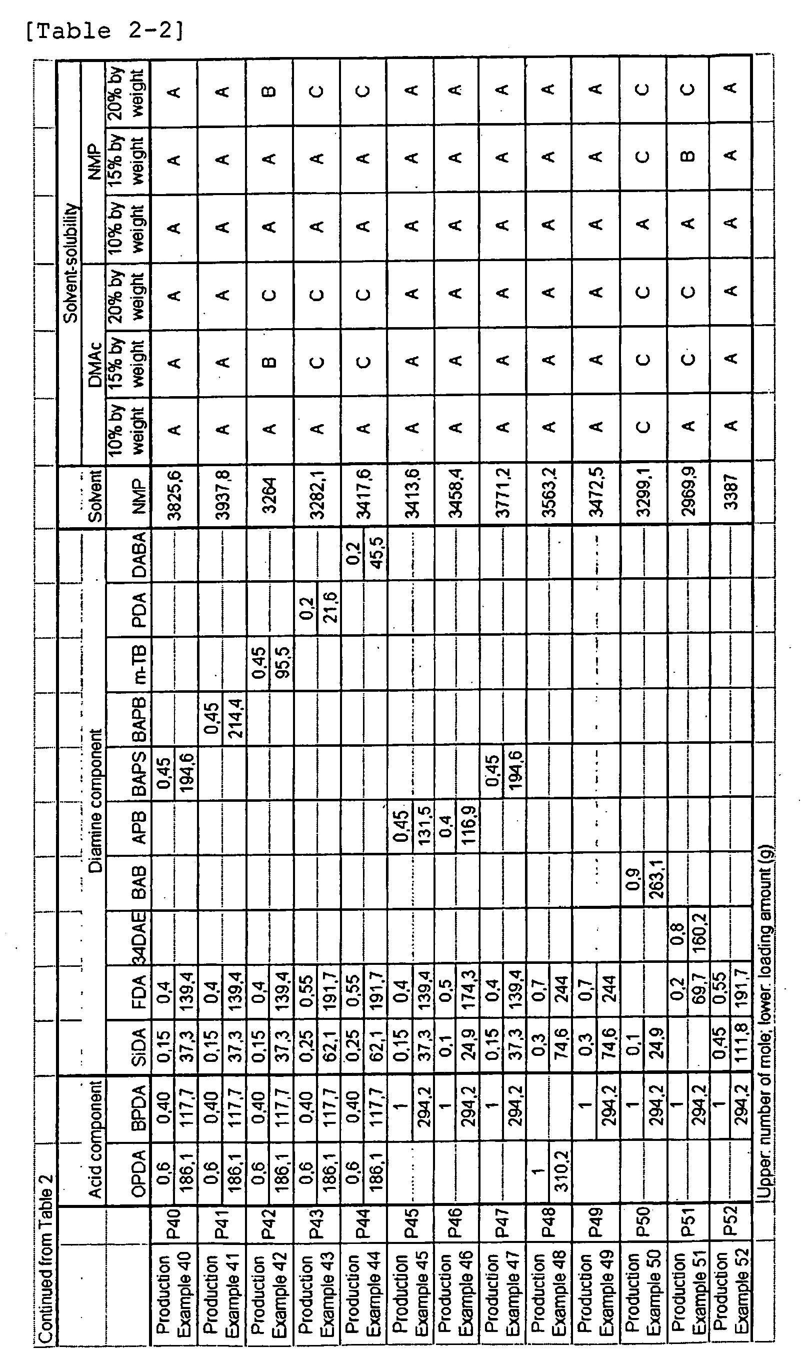

### Example 1

The polyimide powder (P1) was dissolved in a proper amount for adjusting the solid matter concentration to be 15% by weight in DMAc to obtain a polyimide resin solution with a concentration of 15% by weight concentration (PS1).

The polyimide resin solution (PS1) obtained in the above-mentioned manner was applied with a reverse coater in a proper amount for adjusting the film thickness to be 3 µm after drying to a 25 µm-thick polyimide film (Kapton (registered trademark) 100 EN, manufactured by Du Pont - Toray Co., Ltd.) which was previously treated by low temperature plasma treatment in argon atmosphere and dried at 150°C for 2 minutes and then further dried at 180°C for 1 hour to obtain a laminate film of polyimide film/heat resistant resin layer structure.

A 18 µm-thick rolled copper foil (BHY, manufactured by Nikko Materials Co., Ltd.) surface-roughened in the adhesion face side was laminated on the heat resistant resin layer of the produced laminate film of polyimide film/heat resistant resin layer structure and pressure-bonded at a linear pressure of 70 N/mm and a speed of 1 m/min by a roll laminator whose roll surface temperature was heated to 360°C to obtain a laminate film bearing a copper layer in one face. At the time of the pressure bonding, as shown in Fig. 3, a 125 µm polyimide film (Kapton (registered trademark) 500 H, manufactured by Du Pont - Toray Co., Ltd.) as a protection film was inserted between both rolls and the laminate film/copper foil.

When the adhesive strength of the obtained laminate film bearing a copper layer in one face was measured, the adhesive strength was 8 N/cm and the soldering heat resistance was 290°C. Further, the glass transition temperature of the heat resistant resin layer was 289°C. The bonding durability was also measured to find that neither subsidence of the wiring in the heat resistant resin layer occurred nor peeling of the wiring was caused.

### Examples 2 to 17

The polyimide powders (P2 to P13 and P 17) were dissolved in a proper amount for adjusting the solid matter concentration to be 15% by weight in DMAc to obtain polyimide resin solutions with a concentration of 15% by weight concentration (PS2 to PS13 and PS17). Further, the polyimide powder (P14) was dissolved in a proper amount for adjusting the solid matter concentration to be 10% by weight in DMAc to obtain a polyimide resin solution with a concentration of 10% by weight concentration (PS14). The polyimide powders (P5 and P 14) were dissolved in a proper amount for adjusting the solid matter concentration to be 15% by weight in NMP to obtain polyimide resin solutions with a concentration of 15% by weight concentration (PS18 and PS19).

The same process was carried out as Example 1, except that the polyimide resin solutions, the polyimide films, and the copper foils were changed as shown in Table 3 to obtain laminate films each having a copper layer in one face side. The polyimide films used here were Kapton (registered trademark) 100 EN (thickness of 25 µm) manufactured by Du Pont - Toray Co., Ltd.); Kapton (registered trademark) 100 H (thickness of 25 µm) manufactured by Du Pont - Toray Co., Ltd.); and Upilex (registered trademark) 25S (thickness of 25 µm) manufactured by Ube Industries, Ltd.). Further, the copper foil used here was the rolled copper foil BHY (thickness of 18 µm) surface-roughened in the adhesive face side and manufactured by Nikko Materials Co., Ltd and the electrolytic copper foil TQ-VLP (thickness of 12 µm) manufactured by Mitsui Mining and Smelting Co., Ltd. The results of measurements of the adhesion strength, the soldering heat resistance, the glass transition temperature of the heat resistant resin layer, and the bonding durability of the laminate films each bearing the copper layer in one face are shown in Table 3.

### Comparative Examples 1 to 10

Since the polyimide powder (P18) was inferior in solubility in DMAc and also insufficient in the solubility in NMP, the powder was dissolved properly for adjusting the solid matter concentration to be 10% by weight in NMP to obtain a polyimide resin solution with 10% by weight concentration (PS20).

Since the polyimide powders (P19 to P21) were inferior in solubility in DMAc, the powders were dissolved properly for adjusting the solid matter concentration to be 15% by weight in NMP to obtain polyimide resin solutions with 15% by weight concentration (PS21 to PS23).

The polyimide powders (P22 to P25, P15 and P16) were dissolved properly for adjusting the solid matter concentration to be 15% by weight in DMAc to obtain polyimide resin solutions with 15% by weight concentration (PS24 to PS27, PS15 and PS16).

The same process was carried out as Example 1 to obtain laminate films each bearing a copper layer in one side, except that the polyimide resin solutions, polyimide films, and the copper foils were changed as shown in Table 3. The results of measurements of the adhesion strength, the soldering heat resistance, the glass transition temperature of the heat resistant resin layer, and the bonding durability of the obtained laminate films each bearing the copper layer in one face are shown in Table 3.
[Table 3-1]

**[Table 3-1]**

| Table 3 | | | | | | | | | | | |
|---|---|---|---|---|---|---|---|---|---|---|---|
| | Polyimide resin solution | | | | | | Adhesion strength | Soldering heat resistance | Glass transition temperature of the heat resistant resin layer | Bonding durability | |
| | | Concentration | Polyimide | Solvent | Polyimide | Copper | | | | Subsidence of wiring | Peeling of wiring |
| | | (% by weight) | powder | | film | foil | (N/cm) | (°C) | (°C) | | |
| Example 1 | PS1 | 15 | P1 | DMAC | Kapton 100EN | BHY | 8 | 290 | 289 | Not occurred | Not occurred |
| Example 2 | PS2 | 15 | P2 | DMAc | Upilex 25S | TQ-VLP | 8 | 270 | 262 | Not occurred | Not occurred |
| Example 3 | PS3 | 15 | P3 | DMAc | Kapton 100EN | TQ-VLP | 7 | 280 | 302 | Not occurred | Not occurred |
| Example 4 | PS4 | 15 | P4 | DMAc | Kapton 100H | BHY | 8 | 260 | 236 | Not occurred | Not occurred |
| Example 5 | PS5 | 15 | P5 | DMAc | Kapton 100EN | BHY | 9 | 270 | 257 | Not occurred | Not occurred |
| Example 6 | PS6 | 15 | P6 | DMAc | Kapton 100EN | BHY | 10 | 270 | 275 | Not occurred | Not occurred |
| Example 7 | PS7 | 15 | P7 | DMAc | Kapton 100H | TQ-VLP | 10 | 260 | 251 | Not occurred | Not occurred |
| Example 8 | PS8 | 15 | P8 | DMAc | Upilex 25S | BHY | 12 | 260 | 279 | Not occurred | Not occurred |
| Example 9 | PS9 | 15 | P9 | DMAc | Kapton 100H | TQ-VLP | 11 | 250 | 237 | Not occurred | Not occurred |
| Example 10 | PS10 | 15 | P10 | DMAc | Kapton 100EN | BHY | 12 | 260 | 255 | Not occurred | Not occurred |
| Example 11 | PS11 | 15 | P11 | DMAc | Kapton 100EN | BHY | 7 | 250 | 241 | Not occurred | Not occurred |
| Example 12 | PS12 | 15 | P12 | DMAc | Upilex 25S | TQ-VLP | 9 | 270 | 262 | Not occurred | Not occurred |
| Example 13 | PS13 | 15 | P13 | DMAc | Kapton 100H | BHY | 9 | 270 | 258 | Not occurred | Not occurred |
| Example 14 | PS14 | 10 | P14 | DMAc | Kapton 100EN | TQ-VLP | 6 | 260 | 234 | Not occurred | Not occurred |

**[Table 3-2]**

| Continued from Table 3 | | | | | | | | | | | |
|---|---|---|---|---|---|---|---|---|---|---|---|
| | Polyimide resin solution | | | | | | Adhesion strength | Soldering heat resistant | Glass transition temperature of the heat resistant resin layer | Bonding durability | |
| | | Concentration | Polyimide | Solvent | Polyimide | Copper | | | | Subsidence of wiring | Peeling of wiring |
| | | (% by weight) | powder | | film | foil | (N/cm) | (°C) | (°C) | | |
| Example 15 | PS17 | 15 | P17 | DMAc | Kapton100EN | BHY | 6 | 240 | 260 | Not occurred | Not occurred |
| Example 16 | PS18 | 15 | P5 | NMP | Kapton 100EN | BHY | 9 | 270 | 257 | Not occurred | Not occurred |
| Example 17 | PS19 | 15 | P14 | NMP | Kapton100EN | TQ-VLP | 6 | 260 | 234 | Not occurred | Notoccurred |
| Comparative Example 1 | PS20 | 10 | P18 | NMP | Kapton 100EN | BHY | 2 | 230 | 268 | Not occurred | Not occurred |
| Comparative Example 2 | PS21 | 15 | P19 | NMP | Kapton 100H | BHY | 4 | 220 | 231 | Not occurred | Not occurred |
| Comparative Example 3 | PS22 | 15 | P20 | NMP | Upilex 25S | BHY | 6 | 200 | 184 | Occurred (considerable) | Occurred (large) |
| Comparative Example 4 | PS23 | 15 | P21 | NMP | Kapton 100EN | BHY | 3 | 290 | 283 | Not occurred | Not occurred |
| Comparative Example 5 | PS24 | 15 | P22 | DMAc | Upilex 25S | TQ-VLP | < 1 | 300 | 384 | Not occurred | Not occurred |
| Comparative Example 6 | PS25 | 15 | P23 | DMAc | Kapton 100EN | BHY | 1 | 300 | 330 | Not occurred | Not occurred |
| Comparative Example 7 | PS26 | 15 | P24 | DMAc | Kapton 100EN | BHY | < 1 | 300 | 364 | Not occurred | Not occurred |
| Comparative Example 8 | PS27 | 15 | P25 | DMAc | Kapton 100H | TQ-VLP | 8 | 220 | 186 | Occurred (considerable) | Occurred (large) |
| Comparative Example 9 | PS15 | 15 | P15 | DMAc | Kapton 100EN | BHY | 6 | 220 | 252 | Not occurred | Not occurred |
| Comparative Example 10 | PS16 | 15 | P16 | DMAc | Kapton 100EN | BHY | 6 | 210 | 255 | Not occurred | Not occurred |

### Comparative Example 11

At first, 44DAE 200.2 g (1 mol) was loaded together with DMAc 2892 g to a reaction vessel equipped with a thermometer, a dry nitrogen introduction inlet, a heating and cooling apparatus using hot water and cold water, and a stirrer and dissolved. After that, OPDA 310.2 g (1 mol) was added and reaction was carried out at 70°C for 4 hours to polymerize the polyamide acid and obtain a polyamide acid solution in a concentration of 15% by weight concentration (PA1).

The polyamide acid solution (PA1) obtained in the above-mentioned manner was applied in a proper amount for adjusting the film thickness to be 3 µm after drying to a 25 µm-thick polyimide film (Kapton (registered trademark) 100 EN, manufactured by Du Pont - Toray Co., Ltd.) which was previously treated by low temperature plasma treatment in argon atmosphere with a reverse coater and dried at 150°C for 2 minutes and then further dried at 180°C for 1 hour to obtain a laminate film of polyimide film/heat resistant resin layer structure.

When 18 µm-thick rolled copper foil (BHY, manufactured by Nikko Materials Co., Ltd.) surface-roughened in the adhesion face side was laminated on the heat resistant resin layer of the produced laminate film of polyimide film/heat resistant resin layer structure and pressure-bonded at a linear pressure of 70 N/mm and a speed of 1 m/min by a roll laminator whose roll surface temperature was heated to 360°C, many foams were formed in the heat resistant resin layer and thus it was impossible to obtain a laminate film bearing a copper layer in one face. At the time of the pressure bonding, as shown in Fig. 3, a 125 µm polyimide film (Kapton (registered trademark) 500 H, manufactured by Du Pont - Toray Co., Ltd.) as a protection film was inserted between both rolls and the laminate film/copper foil.

### Example 18

The polyimide resin solution (PS5) was applied in a proper amount for adjusting the film thickness to be 3 µm after drying to a 25 µm-thick polyimide film (Kapton (registered trademark) 100 EN, manufactured by Du Pont - Toray Co., Ltd.) which was previously treated by low temperature plasma treatment in argon atmosphere with a reverse coater and dried at 150°C for 2 minutes and then the polyimide resin solution (PS5) was further applied in a proper amount for adjusting the film thickness to be 3 µm after drying to the other face with a reverse coater and dried at 150°C for 2 minutes and then the solution was further dried at 180°C for 1 hour to obtain a laminate film of polyimide film/heat resistant resin layer structure.

A 18 µm-thick rolled copper foil (BHY, manufactured by Nikko Materials Co., Ltd.) surface-roughened in the adhesion face side was laminated on both of the heat resistant resin layers of the produced laminate film of polyimide film/heat resistant resin layer structure and pressure-bonded at a linear pressure of 70 N/mm and a speed of 1 m/min by a roll laminator whose roll surface temperature was heated to 360°C to obtain a laminate film bearing copper layers in both faces. At the time of the pressure bonding, as shown in Fig. 4, a 125 µm polyimide film (Kapton (registered trademark) 500 H, manufactured by Du Pont - Toray Co., Ltd.) as a protection film was inserted between both rolls and the copper foil in both sides, respectively. When the adhesion strength of the obtained laminate film bearing copper layers in both faces was measured, it was 9 N/cm.

### Production Examples 19 to 46

The polyimide powders (P26 to P35, P38 to P41, and P45 to P49) were dissolved in a proper amount for adjusting the solid matter concentration to be 15% by weight in DMAc to obtain polyimide resin solutions with a concentration of 15% by weight concentration (PS28 to PS37, PS40 to PS43, and PS47 to PS51).

Since the polyimide powders (P36 and P37, P42 to P44) were insufficient in solubility in DMAc, the powders were dissolved properly for adjusting the solid matter concentration to be 15% by weight in NMP to obtain polyimide resin solutions with 15% by weight concentration (PS38 and PS39, and PS44 to PS46).

Further, the polyimide powders (P26, P28, P45, and P46) were dissolved properly for adjusting the solid matter concentration to be 15% by weight in NMP to obtain a polyimide resin solutions with 15% by weight concentration (PS52 to PS55).

The same process was carried out as Example 1, except that the polyimide resin solutions, the polyimide films, and the copper foils were changed as shown in Table 4 to obtain laminate films each having a copper layer in one face side. The results of measurements of the adhesion strength, the soldering heat resistance, the glass transition temperature of the heat resistant resin layer, and the bonding durability of the laminate films each bearing the copper layer in one face are shown in Table 4.

### Comparative Examples 12 to 14

Since the polyimide powders (P50 and P51) were inferior in solubility in DMAc and also insufficient in the solubility in NMP, the powders were dissolved properly for adjusting the solid matter concentration to be 10% by weight in NMP to obtain polyimide resin solutions with 10% by weight concentration (PS56 and PS57).

The polyimide powder (P52) was dissolved properly for adjusting the solid matter concentration to be 15% by weight in DMAc to obtain polyimide resin solution with 15% by weight concentration (PS58).

The same process was carried out as Example 1, except that the polyimide resin solutions, the polyimide films, and the copper foils were changed as shown in Table 4 to obtain laminate films each having a copper layer in one face side. The results of measurements of the adhesion strength, the soldering heat resistance, the glass transition temperature of the heat resistant resin layer, and the bonding durability of the laminate films each bearing the copper layer in one face are shown in Table 4.

**[Table 4-1]**

| Table 4 | | | | | | | | | | | |
|---|---|---|---|---|---|---|---|---|---|---|---|
| | Polyimide resin solution | | | | | | Adhesion strength | Soldering heat resistance | Glass transition temperature of the heat resistant resin layer | Bonding durability | |
| | | Concentration | Polyimide | Solvent | Polyimide | Copper | | | | Subsidence of wiring | Peeling of wiring |
| | | (% by weight) | powder | | film | foil | (N/cm) | (°C) | (°C) | | |
| Example 19 | PS28 | 15 | P26 | DMAc | Kapton 100EN | BHY | 12 | 270 | 253 | Not occurred | Not occurred |
| Example 20 | PS29 | 15 | P27 | DMAc | Upilex 25S | TQ-VLP | 12 | 280 | 263 | Not occurred | Not occurred |
| Example 21 | PS30 | 15 | P28 | DMAc | Kapton 100EN | BHY | 11 | 290 | 270 | Not occurred | Not occurred |
| Example 22 | PS31 | 15 | P29 | DMAc | Kapton 100EN | TQ-VLP | 11 | 290 | 278 | Not occurred | Not occurred |
| Example 23 | PS32 | 15 | P30 | DMAc | Kapton 100H | BHY | 10 | 300 | 288 | Not occurred | Not occurred |
| Example 24 | PS33 | 15 | P31 | DMAc | Kapton 100EN | BHY | 9 | 300 | 296 | Not occurred | Not occurred |
| Example 25 | PS34 | 15 | P32 | DMAc | Upilex 25S | TQ-VLP | 11 | 260 | 219 | Occurred (light) | Occurred (small) |
| Example 26 | PS35 | 15 | P33 | DMAc | Kapton 100EN | BHY | 9 | 270 | 237 | Not occurred | Not occurred |
| Example 27 | PS36 | 15 | P34 | DMAc | Kapton 100EN | BHY | 10 | 240 | 203 | Occurred (light) | Occurred (small) |
| Example 28 | PS37 | 15 | P35 | DMAc | Kapton 100EN | BHY | 6 | 300 | 289 | Not occurred | Not occurred |
| Example 29 | PS38 | 15 | P36 | NMP | Kapton 100EN | BHY | 6 | 290 | 287 | Not occurred | Not occurred |
| Example 30 | PS39 | 15 | P37 | NMP | Kapton 100EN | TQ-VLP | 6 | 290 | 293 | Not occurred | Not occurred |
| Example 31 | PS40 | 15 | P38 | DMAc | Upilex 25S | BHY | 8 | 280 | 280 | Not occurred | Not occurred |
| Example 32 | PS41 | 15 | P39 | DMAc | Kapton 100EN | TQ-VLP | 10 | 280 | 239 | Not occurred | Not occurred |
| Example 33 | PS42 | 15 | P40 | DMAc | Kapton 100EN | BHY | 8 | 280 | 254 | Not occurred | Not occurred |
| Example 34 | PS43 | 15 | P41 | DMAc | Kapton 100EN | BHY | 9 | 240 | 219 | Occurred (light) | Occurred (small) |

**[Table 4-2]**

| Continued from Table 4 | | | | | | | | | | | |
|---|---|---|---|---|---|---|---|---|---|---|---|
| | Polyimide resin solution | | | | | | Adhesion | Soldering heat resistance | Glass transition temperature of the heat resistant resin layer | Bonding durability | |
| | | Concentration | Polyimide | Solvent | Polyimide | Copper | | | | Subsidence of wiring | Peeling of Wiring |
| | | (% by weight) | powder | | film | foil | (N/cm) | (°C) | (°C) | | |
| Example 36 | PS45 | 15 | P43 | NMP | Kapton 100EN | BHY | 6 | 300 | 305 | Not occurred | Not occurred |
| Example 37 | PS46 | 15 | P44 | NMP | Kapton 100EN | TQ-VLP | 6 | 300 | 314 | Not occurred | Not occurred |
| Example 38 | PS47 | 15 | P45 | DMAc | Kapton 100EN | BHY | 12 | 280 | 249 | Not occurred | Not occurred |
| Example 39 | PS48 | 15 | P46 | DMAc | Kapton 100EN | BHY | 11 | 300 | 273 | Not occurred | Not occurred |
| Example 40 | PS49 | 15 | P47 | DMAc | Kapton 100EN | TQ-VLP | 8 | 280 | 270 | Not occurred | Not occurred |
| Example 41 | PS50 | 15 | P48 | DMAc | Kapton 100EN | BHY | 6 | 270 | 250 | Not occurred | Not occurred |
| Example 42 | PS51 | 15 | P49 | DMAc | Kapton 100EN | TQ-VLP | 6 | 280 | 288 | Not occurred | Not occurred |
| Example 43 | PS52 | 15 | P26 | NMP | Kapton 100EN | BHY | 12 | 270 | 253 | Not occurred | Not occurred |
| Example 44 | PS53 | 15 | P28 | NMP | Upilex 25S | TQ-VLP | 11 | 290 | 270 | Not occurred | Not occurred |
| Example 45 | PS54 | 15 | P45 | NMP | Upilex 25S | TQ-VLP | 12 | 280 | 249 | Not occurred | Not occurred |
| Example 46 | PS55 | 15 | P46 | NMP | Kapton 100EN | BHY | 11 | 300 | 273 | Not occurred | Not occurred |
| Comparative Example 12 | PS56 | 10 | P50 | NMP | Kapton 100EN | BHY | 3 | 230 | 254 | Not occurred | Not occurred |
| Comparative Example 13 | PS57 | 10 | P51 | NMP | Kapton 100EN | BHY | 3 | 290 | 301 | Not occurred | Not occurred |
| Comparative Example 14 | PS58 | 15 | P52 | DMAc | Kapton 100EN | TQ-VLP | 6 | 220 | 210 | Occurred (light) | Occurred (small) |

As described, in Examples within the scope of the invention showed excellent solubility not only in NMP but also in DMAc and copper layer-bearing laminate films of the invention were found having excellent adhesiveness and soldering heat resistance. Further, since the glass transition temperature of the heat resistant resin layer was in a proper range, subsidence or peeling of the wiring was scarcely caused even in the bonding during which high temperature and high pressure were applied.

On the other hand, Comparative Examples were found insufficient in the solvents or even if the solubility was sufficient, the adhesiveness was low and/or the soldering heat resistance was inferior in the copper layer-bearing laminate films. In the case of Comparative Example 8, although the solubility in the solvents and the adhesiveness in form of the copper layer-bearing laminate film were sufficient, the soldering heat resistance was low and the glass transition temperature of the heat resistant resin layer was out of the proper range, so that the subsidence of the wiring in the bonding durability measurement was significant and peeling of the wiring was considerably caused.

Further, in the case of Comparative Example 11, since the heat resistant resin layer was still in a polyamide acid sate, imidation reaction of the heat resistant resin layer was caused at the time of lamination and the heat resistant resin layer was foamed due to water produced at the time of lamination to make it impossible to obtain a desirable copper layer-bearing laminate film.

### [Industrial Applicability]

The invention provides an innovative polyimide resin having sufficient solubility in an organic solvent and high heat resistance. Further, the invention provides a laminate film comprising a heat resistant insulation film and the polyimide resin layered thereon and also a laminate film having high adhesion strength and high soldering heat resistance by using a metal layer-bearing laminate film comprising the a metal layer formed on the laminate film. Since the metal layer-bearing laminate film of the invention is excellent in the mechanical heat resistance and scarcely causes resin deformation even in process such as IC bonding and high temperature press in which high pressure is applied at a high temperature, a semiconductor device with high reliability can be obtained.

## Claims

1. A laminate film comprising a heat resistant insulation film and a heat resistant resin layer formed at least on one face of the insulation film, wherein the heat resistant resin layer contains a polyimide resin containing at least an acid dianhydride residual group and a diamine residual group and having a glass transition temperature in a range from 200 to 320°C, wherein the diamine residual group includes a residual group of a siloxane type diamine defined by the formula (1) and a residual group of a fluorene type diamine defined by the formula (2) in 2 to 40% by mole of the siloxane type diamine residual group and 4 to 82% by mole of the fluorene type diamine residual group in the total diamine residual groups; the acid dianhydride residual group includes a residual group of at least one acid dianhydride selected from tetracarboxylic acid dianhydrides defined by the formula (3) and tetracarboxylic acid dianhydrides defined by the formula (4): 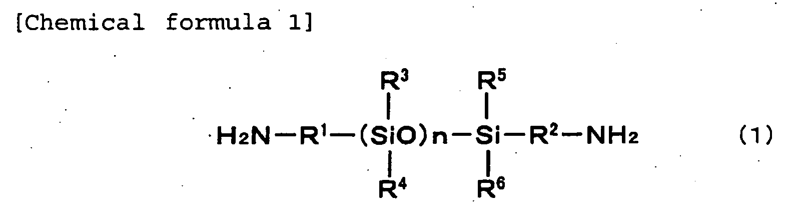 wherein the reference character n denotes a numeral in a range from 1 to 30; R¹ and R² may be same or different and independently denote an alkylene group of 1 to 30 carbon atoms or a phenylene group; R³ to R⁶ may be same or different and independently denote an alkyl group of 1 to 30 carbon atoms, a phenyl group, or a phenoxy group: 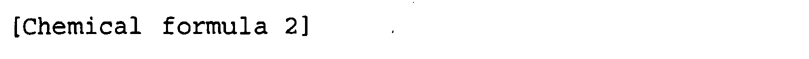 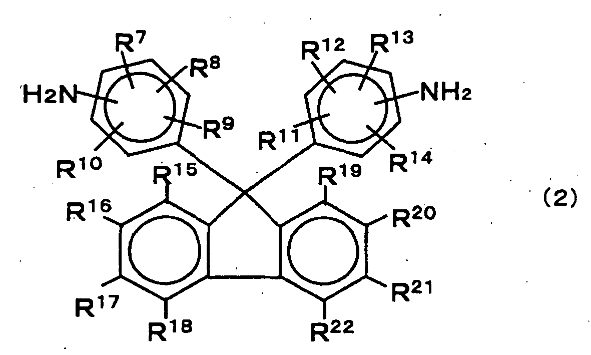 wherein R⁷ to R²² may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, and a cyano group: 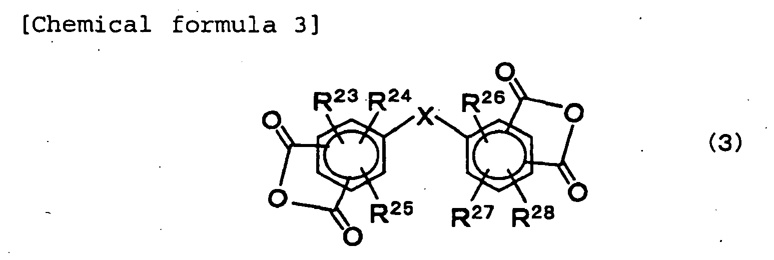 wherein X is selected from O, CO, S, SO, CH₂, C(CH₃)₂, and C(CF₃)₂; R²³ to R²⁸ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group: and 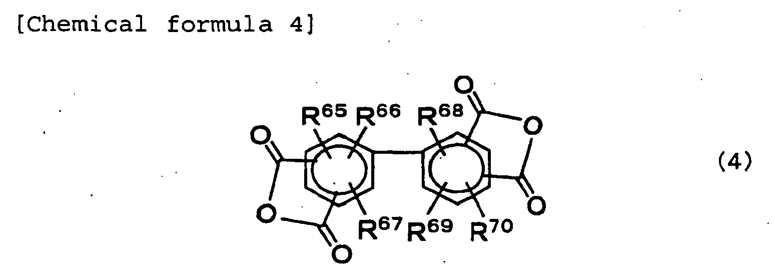 wherein R⁶⁵ to R⁷⁰ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group.

2. The laminate film according to claim 1, wherein the tetracarboxylic acid dianhydride comprises O for X in the formula (3).

3. The laminate film according to claim 1 or 2, wherein the polyimide resin further comprises a residual group of one or more aromatic diamine selected from aromatic diamines defined by the following formula (5) 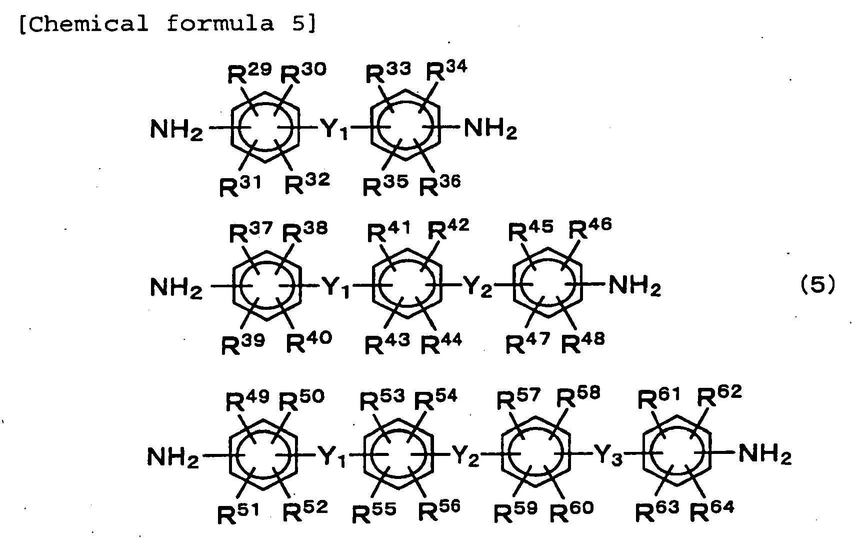 wherein Y₁ to Y₃ may be same or different and selected from O, CO, S, SO, SO₂, CH₂, C(CH₃)₂, and C(CF₃)₂; R²⁹ to R⁶⁴ may be same or different and independently denote a group selected from hydrogen atom, an alkyl group of 1 to 30 carbon atoms, an alkoxy group of 1 to 30 carbon atoms, a halogen, a hydroxyl group, a carboxyl group, a sulfone group, a nitro group, or a cyano group.

4. A metal layer-bearing laminate film comprising the laminate film according to claim 1 and a metal layer formed on the heat resistant resin layer side of the laminate film.

5. A semiconductor device using the metal layer-bearing laminate film according to claim 4.

## Patentansprüche

1. Ein Laminatfilm, der einen wärmebeständigen Isolationsfilm und eine auf mindestens einer Seite des Isolationsfilms gebildete wärmebeständige Harzschicht umfasst, wobei die wärmebeständige Harzschicht ein Polyimidharz enthält, das mindestens einen Säuredianhydridrest und einen Diaminrest enthält und eine Glasübergangstemperatur in einem Bereich von 200 bis 320°C aufweist, wobei der Diaminrest einen durch die Formel (1) definierten Siloxandiaminrest und einen durch die Formel (2) definierten Fluorendiaminrest mit 2 bis 40 Mol-% des Siloxandiaminrests und 4 bis 82 Mol-% des Fluorendiaminrests in den gesamten Diaminresten einschließt; wobei der Säuredianhydridrest einen Rest von mindestens einem Säuredianhydrid einschließt, das aus durch die Formel (3) definierten Tetracarboxylsäuredianhydriden und durch die Formel (4) definierten Tetracarboxylsäuredianhydriden ausgewählt ist: 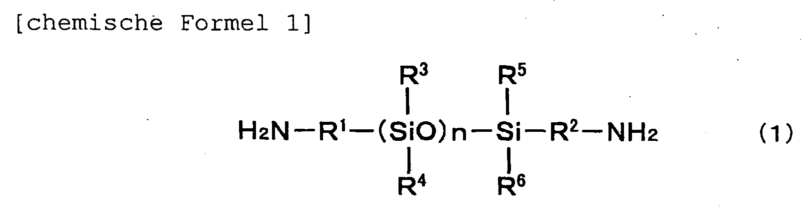 wobei das Bezugszeichen n eine Zahl im Bereich von 1 bis 30 bezeichnet; R¹ und R² gleich oder verschieden sein können und unabhängig voneinander eine Alkylengruppe mit 1 bis 30 Kohlenstoffatomen oder eine Phenylengruppe bezeichnen; R³ bis R⁶ gleich oder verschieden sein können und unabhängig voneinander eine Alkylgruppe mit 1 bis 30 Kohlenstoffatomen, eine Phenylgruppe oder eine Phenoxygruppe bezeichnen; 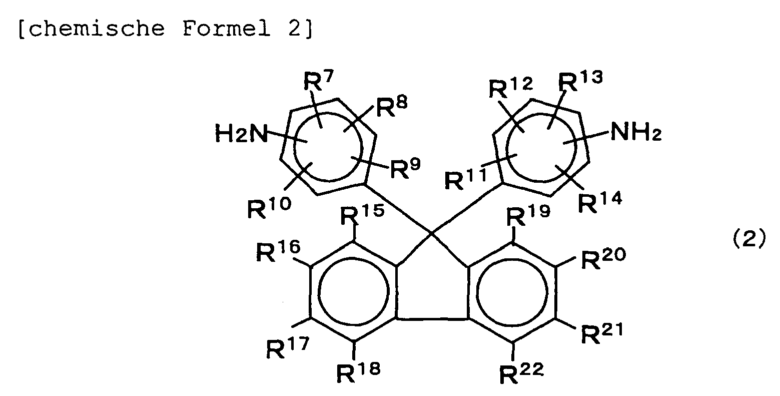 wobei R⁷ bis R²² gleich oder verschieden sein können und unabhängig voneinander eine aus Wasserstoffatom, einer Alkylgruppe mit 1 bis 30 Kohlenstoffatomen, einer Alkoxygruppe mit 1 bis 30 Kohlenstoffatomen, einem Halogen, einer Hydroxylgruppe, einer Carboxylgruppe, einer Sulfongruppe, einer Nitrogruppe und einer Cyangruppe ausgewählte Gruppe bezeichnen; 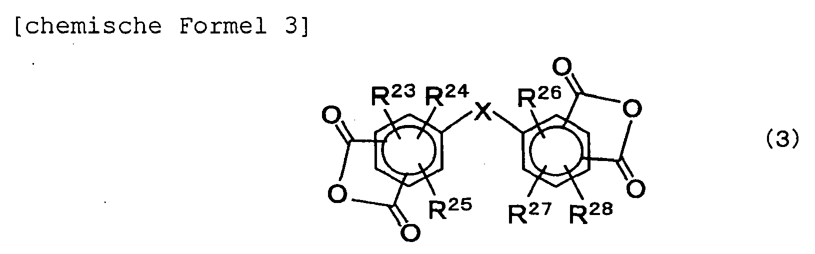 wobei X aus O, CO, S, SO, CH₂, C(CH₃)₂ und C(CF₃)₂ ausgewählt ist; R²³ bis R²⁸ gleich oder verschieden sein können und unabhängig voneinander eine aus Wasserstoffatom, einer Alkylgruppe mit 1 bis 30 Kohlenstoffatomen, einer Alkoxygruppe mit 1 bis 30 Kohlenstoffatomen, einem Halogen, einer Hydroxylgruppe, einer Carboxylgruppe, einer Sulfongruppe, einer Nitrogruppe oder einer Cyangruppe ausgewählte Gruppe bezeichnen; und 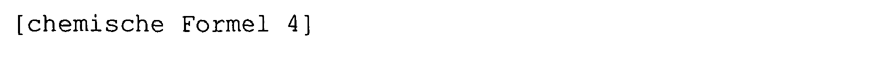 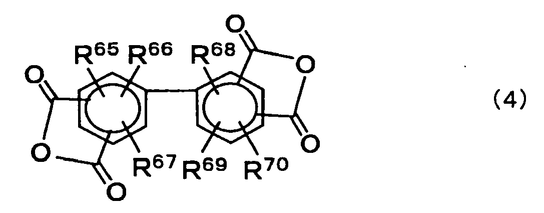 wobei R⁶⁵ bis R⁷⁰ gleich oder verschieden sein können und unabhängig voneinander eine aus Wasserstoffatom, einer Alkylgruppe mit 1 bis 30 Kohlenstoffatomen, einer Alkoxygruppe mit 1 bis 30 Kohlenstoffatomen, einem Halogen, einer Hydroxylgruppe, einer Carboxylgruppe, einer Sulfongruppe, einer Nitrogruppe oder einer Cyangruppe ausgewählte Gruppe bezeichnen.

2. Laminatfilm gemäß Anspruch 1, wobei das Tetracarboxylsäuredianhydrid in Formel (3) O für X aufweist.

3. Laminatfilm gemäß Anspruch 1 oder 2, wobei das Polyimidharz einen Rest mit einem oder mehreren aromatischen Diamin(en) umfasst, das (die) aus durch die folgende Formel (5) definierten aromatischen Diaminen ausgewählt ist (sind); 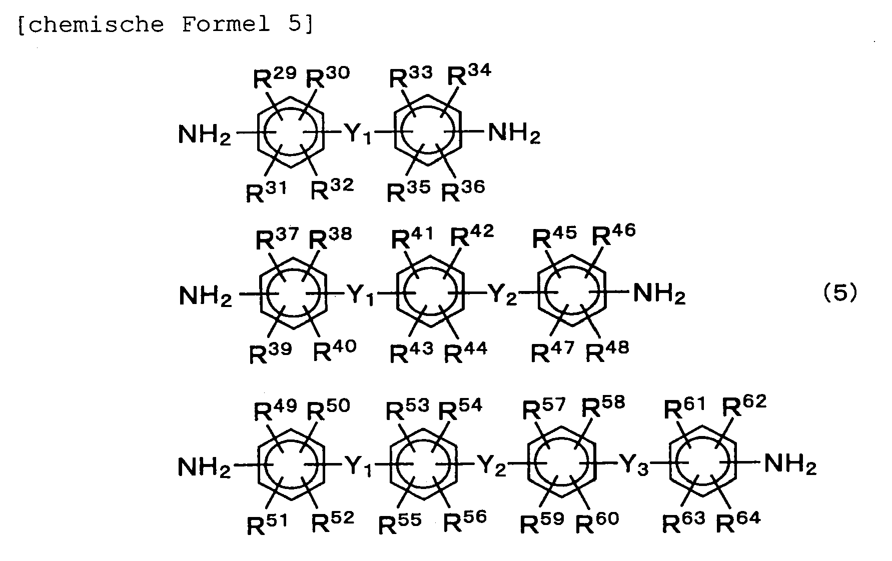 wobei Y₁ bis Y₃ gleich oder verschieden sein können und aus O, CO, S, SO, SO₂ CH₂, C(CH₃)₂ und C(CF₃)₂ ausgewählt sind; R²⁹ bis R⁶⁴ gleich oder verschieden sein können und unabhängig voneinander eine aus Wasserstoffatom, einer Alkylgruppe mit 1 bis 30 Kohlenstoffatomen, einer Alkoxygruppe mit 1 bis 30 Kohlenstoffatomen, einem Halogen, einer Hydroxylgruppe, einer Carboxylgruppe, einer Sulfongruppe, einer Nitrogruppe oder einer Cyangruppe ausgewählte Gruppe bezeichnen.

4. Ein eine Metallschicht tragender Laminatfilm, der den Laminatfilm gemäß Anspruch 1 und eine auf der wärmebeständigen Harzschichtseite des Laminatfilms gebildete Metallschicht umfasst.

5. Ein Halbleiterbauelement, das der Metallschicht tragende Laminatfilm gemäß Anspruch 4 verwendet.

## Revendications

1. Film laminé comprenant un film d'isolation résistant à la chaleur et une couche de résine résistante à la chaleur formée au moins sur une face du film d'isolation, dans lequel la couche de résine résistante à la chaleur contient une résine de polyimide contenant au moins un groupement résiduel de dianhydride d'acide et un groupement résiduel de diamine et possédant une température de transition vitreuse située dans la plage allant de 200 à 320 °C, dans lequel le groupement résiduel de diamine inclut un groupement résiduel d'une diamine de type siloxane définie par la formule (1) et un groupement résiduel d'une diamine de type fluorène définie par la formule (2) à raison de 2 à 40 % en moles du groupement résiduel de diamine de type siloxane et de 4 à 82 % en moles du groupement résiduel de diamine de type fluorène au sein des groupements résiduels de diamine totaux ; le groupement résiduel de dianhydride d'acide inclut un groupement résiduel d'au moins un dianhydride d'acide choisi parmi les dianhydrides d'acides tétracarboxyliques définis par la formule (3) et les dianhydrides d'acides tétracarboxyliques définis par la formule (4) : 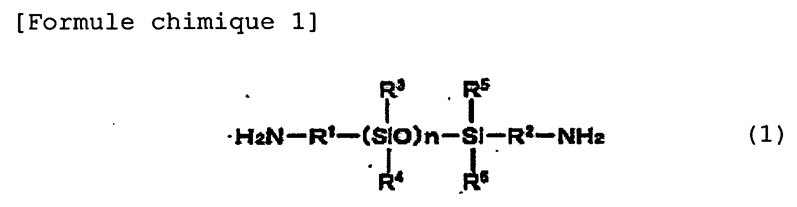 dans laquelle le caractère de référence n représente un nombre situé dans une plage allant de 1 à 30 ; R¹ et R² peuvent être les mêmes ou différents et représentent indépendamment un groupement alkylène, de 1 à 30 atomes de carbone ou un groupement phénylène ; R³ et R⁶ peuvent être les mêmes ou différents et représentent un groupement alkyle de 1 à 30 atomes de carbone, un groupement phényle, ou un groupement phénoxy : 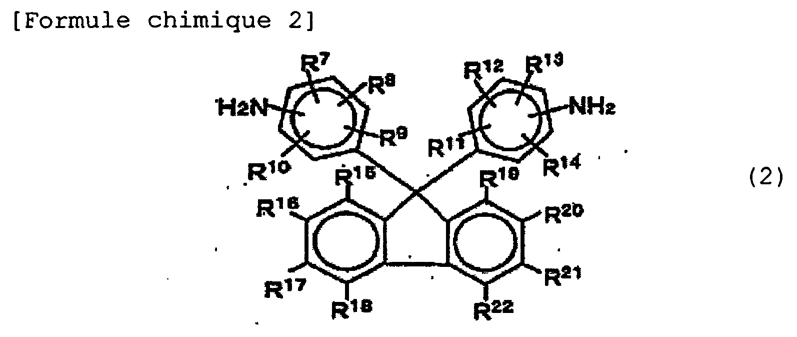 dans laquelle R⁷ à R²² peuvent être les mêmes ou différents et représentent indépendamment un groupement choisi parmi un atome d'hydrogène, un groupement alkyle de 1 à 30 atomes de carbone, un groupement alcoxy de 1 à 30 atomes de carbone, un halogène, un groupement hydroxyle, un groupement carboxyle, un groupement sulfone, un groupement nitro, et un groupement cyano : 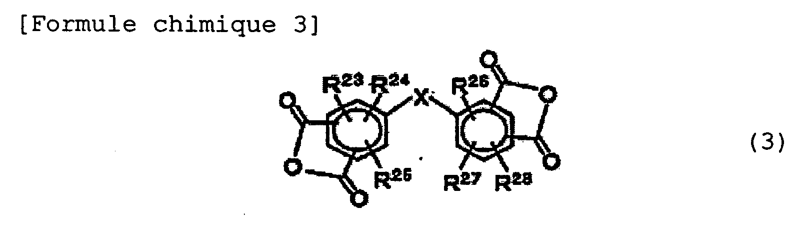 dans laquelle X est choisi parmi un O, un CO, un S, un SO, un CH₂, un C(CH₃)₂ et un C(CF₃)₂ ; R²³ à R²⁸ peuvent être les mêmes ou différents et représentent indépendamment un groupement choisi parmi un atome d'hydrogène, un groupement alkyle de 1 à 30 atomes de carbone, un groupement alcoxy de 1 à 30 atomes de carbone, un halogène, un groupement hydroxyle, un groupement carboxyle, un groupement sulfone, un groupement nitro, ou un groupement cyano : 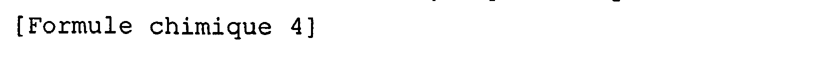 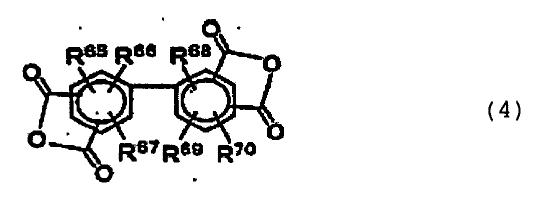 dans laquelle R⁶⁵ à R⁷⁰ peuvent être les mêmes ou différents et représentent indépendamment un groupement choisi parmi un atome d'hydrogène, un groupement alkyle de 1 à 30 atomes de carbone, un groupement alcoxy de 1 à 30 atomes de carbone, un halogène, un groupement hydroxyle, un groupement carboxyle, un groupement sulfone, un groupement nitro, ou un groupement cyano.

2. Film laminé selon la revendication 1, dans lequel le dianhydride d'acide tétracarboxylique comprend un O pour X dans la formule (3).

3. Film laminé selon la revendication 1 ou 2, dans lequel la résine de polyimide comprend en outre un groupement résiduel d'une ou plusieurs diamines aromatiques choisies parmi les diamines aromatiques définies par la formule (5) suivante : 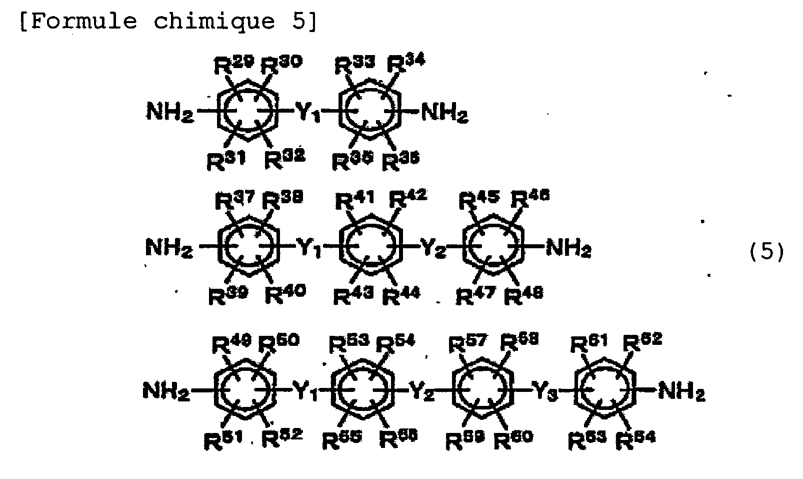 dans laquelle Y₁ à Y₃ peuvent être les mêmes ou différents et choisis parmi un O, un CO, un S, un SO, un SO₂, un CH₂, un C(CH₃)₂ et un C(CF₃)₂ ; R²⁹ à R⁶⁴ peuvent être les mêmes ou différents et représentent indépendamment un groupement choisi parmi un atome d'hydrogène, un groupement alkyle de 1 à 30 atomes de carbone, un groupement alcoxy de 1 à 30 atomes de carbone, un halogène, un groupement hydroxyle, un groupement carboxyle, un groupement sulfone, un groupement nitro, ou un groupement cyano.

4. Film laminé portant une couche métallique comprenant le film laminé selon la revendication 1 et une couche métallique formée sur le côté de la couche de résine résistante à la chaleur du film laminé.

5. Dispositif semi-conducteur utilisant le film laminé portant une couche métallique selon la revendication 4.
